(19) Europäisches Patentamt / European Patent Office / Office européen des brevets

(11) **EP 3 446 143 B1**

(12) **FASCICULE DE BREVET EUROPEEN**

(45) Date de publication et mention de la délivrance du brevet:
**26.07.2023 Bulletin 2023/30**

(21) Numéro de dépôt: **17785194.6**

(22) Date de dépôt: **12.04.2017**

(51) Classification Internationale des Brevets (IPC):
**G01R 35/04** *(2006.01)*     **G01R 22/06** *(2006.01)*

(52) Classification Coopérative des Brevets (CPC):
**G01R 35/04; G01R 22/066; G01R 22/068**

(86) Numéro de dépôt international:
**PCT/CA2017/050448**

(87) Numéro de publication internationale:
**WO 2017/181272 (26.10.2017 Gazette 2017/43)**

(54) **ÉTALONNAGE EN LIGNE DE COMPTEURS ET DÉTECTION DE NON-CONFORMITÉS ÉLECTRIQUES**

ONLINE-KALIBRIERUNG VON STROMZÄHLERN UND DETEKTION VON ELEKTRISCHEN ABWEICHUNGEN

ONLINE CALIBRATION OF METERS AND DETECTION OF ELECTRICAL NON-CONFORMITIES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.04.2016 CA 2927482**

(43) Date de publication de la demande:
**27.02.2019 Bulletin 2019/09**

(73) Titulaire: **Hydro-Québec**
**Montréal, QC H2Z 1A4 (CA)**

(72) Inventeurs:
• **LÉONARD, François**
**Montréal, Québec H1C 1B1 (CA)**
• **ZINFLOU, Arnaud**
**Longueuil, Québec J4N 0H1 (CA)**
• **VIAU, Mathieu**
**Varennes, Québec J3X 2J7 (CA)**
• **BOUFFARD, Alexandre**
**Saint-Bruno, Québec J3V 4P4 (CA)**

(74) Mandataire: **Plasseraud IP**
**66, rue de la Chaussée d'Antin**
**75440 Paris Cedex 09 (FR)**

(56) Documents cités:
**WO-A1-2016/178998     WO-A1-2016/179005**

WO-A1-2016/206191     CN-A- 102 621 516
CN-A- 102 928 809

• SALINAS SERGIO ET AL: "Privacy-Preserving Energy Theft Detection in Smart Grids: A P2P Computing Approach", IEEE JOURNAL ON SELECTED AREAS IN COMMUNICATIONS, IEEE SERVICE CENTER, PISCATAWAY, US, vol. 31, no. 9, 1 septembre 2013 (2013-09-01), pages 257-267, XP011581679, ISSN: 0733-8716, DOI: 10.1109/JSAC.2013.SUP.0513023 [extrait le 2013-08-23]
• SERGIO SALINAS ET AL: "Privacy-preserving energy theft detection in smart grids", SENSOR, MESH AND AD HOC COMMUNICATIONS AND NETWORKS (SECON), 2012 9TH ANNUAL IEEE COMMUNICATIONS SOCIETY CONFERENCE ON, IEEE, 18 juin 2012 (2012-06-18), pages 605-613, XP032223436, DOI: 10.1109/SECON.2012.6275834 ISBN: 978-1-4673-1904-1
• C. L. SU, W. H. LEE ET AL.: 'Electricity theft detection in low voltage networks with smart meters using state estimation' 2016 IEEE INTERNATIONAL CONFERENCE ON INDUSTRIAL TECHNOLOGY (ICIT 2016, TAIPEI, pages 493 - 498, XP032903976

**Description**

**DOMAINE DE L'INVENTION**

L'invention porte en général sur une méthode de traitement de mesures de consommation fournies par des compteurs présumés être rattachés à un même réseau, et notamment sur une méthode de correction des mesures de consommation et un système informatique exécutant la méthode. La méthode permet notamment un étalonnage en ligne des compteurs et une détection de non-conformités électriques (NCE).

**CONTEXTE**

La spécification d'exactitude ("accuracy") typique d'un compteur est de $\pm 0.5\%$ (Classe 5) ou de $\pm 0.2\%$ (Classe 2) soit, par exemple, respectivement de $\pm 1.25$ V et $\pm 0.5$ V pour une lecture de tension de 250 V. Une telle variation de tension observée pour un raccordement court ayant une résistance de 10 m$\Omega$ correspond respectivement à une variation de courant de 125 A et 50 A dans ce raccordement. À priori, une lecture de tension absolue d'un compteur, utilisée seule, ne pourra permettre de détecter que des non-conformités électriques affichant de grandes amplitudes de déviations de tension. Selon une vue différentielle compteur à compteur, la comparaison de la tension d'un compteur avec les autres compteurs partageant le même réseau basse tension peut signaler des anomalies de moindres amplitudes. À cet effet, il serait utile de pouvoir corriger les divergences d'étalonnage de la mesure de tension entre des compteurs rattachés à un réseau commun pour permettre une détection plus précise des anomalies. Selon une vue différentielle dans le temps pour un même compteur, les variations de la tension mises en rapport avec les variations des courants de charge contiennent une information pertinente à la détection de non-conformités. US 2015/0241488 (Sonderegger) propose une méthode qui utilise une régression linéaire pour lier les variations de tension aux variations de courant mesurées à un compteur et en déduire une corrélation d'impédance. Une impédance anormalement élevée peut signifier un contournement. Aussi, il est mentionné qu'une faible convergence de la régression est un indicateur d'un contournement qui n'est utilisé qu'une partie de la journée. La méthode a le désavantage de ne considérer que la variation de tension d'un compteur en fonction de sa consommation sans regard aux autres tensions et consommations des autres compteurs, ce qui fait qu'elle mélange deux valeurs de résistances, soit la résistance réseau et la résistance de raccordement du compteur au réseau. Il a été découvert dans le cadre de la présente invention que ces deux valeurs de résistance, de même que leur dispersion, sont altérées de façon différente selon le type de NCE présentes. Il serait désirable de disposer d'une méthode plus précise que celles connues dans l'art antérieur, la méthode étant aussi susceptible de fournir un moyen de détection des manipulations de charges pouvant abaisser la résistance apparente de raccordement d'un compteur de façon à tromper certains méthodes de l'art comme celle proposée dans US 2015/0241488 (Sonderegger). US20130191051 (Stocker et al.), US20160117326 (Steigler) et US9013173 (Veinette) fournissent des exemples d'autres méthodes de l'art, ainsi que C. L. SU, W. H. LEE ET AL.: "Electricity theft détection in low voltage networks with smart meters using state estimation"2016 IEEE INTERNATIONAL CONFERENCE ON INDUSTRIAL TECHNOLOGY (ICIT, 2016, pages 493-498, XP032903976, TAIPEI.

SOMMAIRE

Selon une réalisation de l'invention, il est proposé une méthode de correction, par un processeur avec une mémoire, de mesures de consommation prises à intervalles temporels par un ensemble de compteurs présumés être rattachés à un même réseau, selon la revendication 1.

Selon une autre réalisation de l'invention, il est proposé un système de correction de mesures de consommation fournies par des compteurs présumés être rattachés à un même réseau, le système comprenant une unité de traitement ayant un processeur et une mémoire en communication avec le processeur, la mémoire contenant des instructions qui, lorsqu'exécutées par le processeur, entraîne le processeur à réaliser les étapes de la méthode décrite ci-dessus.

Ce qui suit fournit un aperçu de certaines caractéristiques possiblement préférables de l'invention qui doivent être considérées de manière non restrictive et qui seront décrites plus en détails ci-après.

Selon une réalisation de la présente invention, il est proposé une méthode d'étalonnage relative en ligne de compteurs, c'est-à-dire lorsque les compteurs sont en service rattachés sur le réseau. L'étalonnage vise à corriger les erreurs de lecture de tension entre les compteurs partageant un même réseau basse tension, erreurs qui apparaissent statiques et systématiques dans le temps ayant une espérance mathématique non nulle du fait d'un biais d'étalonnage. Pour chaque pas temporel de lecture ou mesure des compteurs, le courant total transité ou le maximum de courant transité sur le réseau est calculé pour sélectionner une cohorte d'échantillons formés par des quantités électriques tirées des mesures des compteurs correspondant à une gamme de charge prédéterminée. Dans une réalisation préférée, la gamme de charge est comprise entre un minimum pour exclure les échantillons possiblement invalides et un maximum de façon à obtenir une population de cohorte suffisante d'échantillons correspondant à une faible charge. Un calcul de coefficients d'étalonnage en tension est alors réalisé à partir de la cohorte. Une tension moyenne non-étalonnée pour chaque compteur et une dispersion de la tension instantanée observée temporellement pour chaque compteur sont calculés en utilisant les échantillons de la cohorte afin de détecter une anomalie pouvant correspondre à une non-conformité électrique. Un raffinement possible consiste à calculer trois valeurs de résistances, soit une résistance réseau, une résistance apparente de raccordement et une résistance totale, ainsi que des valeurs de dispersion sur les estimations de résistance. La résistance réseau d'un compteur est estimée à partir de la variation temporelle de la tension moyenne des compteurs et de la variation du courant du même compteur pour un ensemble d'échantillons qui peut être différent de la cohorte des échantillons retenus. La résistance totale est estimée à partir de la variation temporelle de la tension du compteur et de la variation du courant du même compteur pour le même ensemble d'échantillons que celui utilisé pour le calcul de la résistance réseau. La résistance de raccordement est la différence entre la résistance totale et la résistance réseau. La résistance de raccordement est utilisée pour corriger la chute de tension de chaque compteur pour la cohorte d'échantillons retenus afin de préciser davantage les valeurs des coefficients d'étalonnage. La chute de tension dans le raccordement d'un compteur est générée normalement par le courant mesuré sur ce dernier quand l'installation électrique est conforme. Pour la détection d'une non-conformité, la présence d'une anomalie de la valeur de l'une des résistances ou d'une anomalie de la dispersion d'une valeur de résistance dans le temps est détectée. L'étalonnage en ligne des compteurs permet une modélisation plus précise du réseau et a aussi une fonction métrologique en identifiant les compteurs hors spécifications. Il est à noter qu'un biais constant dans une mesure de tension se reflète dans une même proportion dans une mesure de courant puisque les deux mesures sont comparées à la même référence de tension par un convertisseur sigma-delta équipant usuellement un compteur. La sélection d'une cohorte peut aussi être produite à partir de la dérivée du courant auquel cas l'observation des écarts statistiques de la dérivée de la tension informe sur la présence de NCE.

Une comparaison plus précise des tensions des compteurs à partir d'une cohorte déterminée par les consommations de l'ensemble des compteurs avec les chutes de tension corrigées en regard de la consommation de chaque compteur peut être obtenue avec la méthode selon l'invention.

Dans un raffinement possible, la gamme de charge déterminant la cohorte est remplacée par une gamme de ratio de variation de charge, le ratio étant le rapport de la somme des variations quadratiques de charges des autres compteurs sur le carré de la variation de charge du compteur sous examen. Comme la cohorte d'échantillons sélectionnée correspond aux moments où le compteur sous examen ressort le plus de par son activité, un compte peut être effectué pour les fois où la variation de tension de ce compteur ne correspond pas en grandeur à la variation de courant transité par le compteur. Un compte annuel excédent la dizaine signifie une présence probable d'une commutation de charge ente l'amont et l'aval du compteur.

## DESCRIPTION BRÈVE DES DESSINS

Une description détaillée des réalisations préférées de l'invention sera donnée ci-après en référence avec les dessins suivants:

Figure 1 illustre un exemple générique et non exhaustif de subtilisation où par l'action de différents commutateurs, différents types de subtilisations sont réalisés.

Figure 2 illustre un exemple d'un histogramme de distribution d'une somme des courants pour 39106 échantillons pris à un intervalle de 15 minutes pour un réseau comportant 12 compteurs.

Figure 3 illustre une reprise de l'histogramme présenté à la Figure 2 pour une plus petite échelle de tension avec des classes plus étroites, où un seuil de 43 A correspond à un peu plus de 1 % du nombre total d'échantillons.

Figure 4 illustre un organigramme décrivant un processus de sélection des échantillons qui correspondent à des moments où le réseau transite un courant total minime.

Figure 5 est un graphique illustrant des tensions moyennes sans charge de 8 compteurs sur un réseau.

Figure 6 est un graphique illustrant une dispersion de la tension instantanée observée sur chaque compteur lorsqu'il y a peu de charge transitée sur le même réseau que pour la Figure 5.

Figure 7 est un graphique illustrant une dispersion de la dérivée de tension instantanée observée sur chaque compteur lorsqu'il y a peu de charge transitée sur le même réseau que pour la Figure 5.

Figure 8 est un graphique illustrant des tensions moyennes de 42 compteurs lorsqu'il y a peu de charge transitée sur un réseau.

Figure 9 est un graphique illustrant une dispersion de la tension instantanée observée sur chaque compteur lorsqu'il y a peu de charge transitée sur le même réseau que pour la Figure 8.

Figure 10 est un graphique illustrant une valeur de paramètre de correction de tension pour chaque compteur estimée à partir des mesures lorsqu'il y a peu de charge transitée sur le même réseau que pour la Figure 8.

Figure 11 est un graphique illustrant une résistance apparente de réseau $Z_i$ de chaque compteur en regard d'une chute de tension moyenne observée sur le même réseau que pour la Figure 8, entraînée par une charge commutée par le compteur.

Figure 12 est un graphique illustrant une dispersion relative $ETYZr_i$ de la résistance apparente de raccordement $r_i$ de chaque compteur du même réseau que pour la Figure 8.

Figure 13 est un graphique illustrant un exemple de dispersion relative $ETYZRi$ de résistances réseau de compteurs pour un cas de subtilisation par dérivation alternée.

Figures 14A et 14B sont des graphiques illustrant respectivement une dispersion de la dérivée en tension non corrigée pour un réseau basse tension comprenant quatre compteurs et une dispersion calculée à partir de la tension corrigée pour les chutes de tension correspondantes aux consommations mesurées aux compteurs, les seuils minimal et maximal apparaissant en pointillé.

Figures 15A, 15B et 15C sont des graphiques illustrant respectivement des exemples de valeurs de résistance réseau, résistance de connection et résistance totale obtenues pour le même cas que celui illustré aux Figures 14A et 14B.

Figure 16 est un organigramme illustrant un flux d'information et une connectivité entre les principales étapes de la méthode.

Figure 17 est un diagramme schématique illustrant un exemple de système pouvant réaliser la méthode selon l'invention.

## DESCRIPTION DÉTAILLÉE DES RÉALISATIONS PRÉFÉRÉES

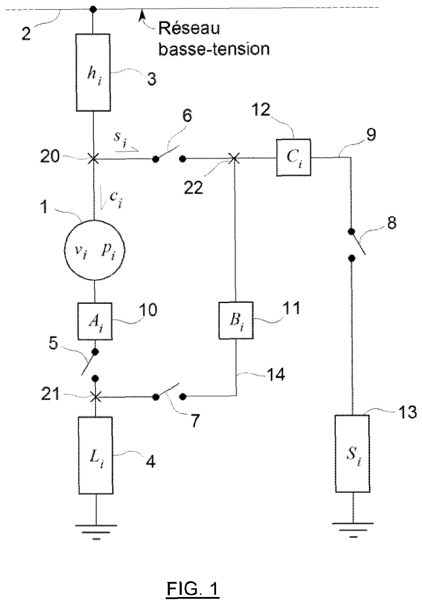

Dans le cadre de cette divulgation, une anomalie électrique attribuable à une subtilisation (réseau biphasé avec neutre) peut être définie comme suit.
En référence à la Figure 1, soit un compteur "$i$" 1 rattaché à un réseau basse tension 2 par un raccordement 3 ayant une résistivité $h_i$. Ce compteur et son circuit le rattachant à un panneau de distribution (non illustré) a une résistance interne $A_i$ 10 et alimente une charge $L_i$ 4 commuté dans le panneau de distribution par un disjoncteur 5.
Il sera appelé "contournement" une insertion d'un circuit composé d'au moins deux branchements illégaux reliant l'amont du compteur 1 à un circuit en son aval. Pour l'exemple général illustré à la Figure 1, un branchement 20 en amont du compteur 1 et un branchement 21 en aval du panneau de distribution constituent un contournement lorsque le commutateur 5 et des commutateurs 6 et 7 sont inexistants ou fermés et qu'un commutateur 8 est en circuit ouvert ou qu'il n'y a pas de circuit de dérivation 9. Le branchement 21 peut aussi être localisé entre le compteur 1 et le panneau de distribution ou peut être relié à plus d'un circuit alimentés par le panneau de distribution. Un commutateur en position 6 ou 7 peut aussi être présent et souvent fermé en même temps que le commutateur 5 est mis ouvert lorsque le responsable de la subtilisation est sur les lieux de subtilisation. En mode contournement, lorsque les commutateurs 5, 6 et 7 sont fermés, le ratio du courant subtilisé sur le courant mesuré est donné par le rapport de la résistance de circuit $A_i$ 10 sur la résistance de circuit $B_i$ 11. Étant donnée la faible grandeur de la résistance $A_i$ 10, usuellement le ratio de subtilisation ne dépasse pas de beaucoup l'unité.
Il sera appelé "dérivation" une insertion d'un circuit entre l'amont du compteur 1 et une charge non alimentée par le compteur 1. Pour l'exemple général illustré à la Figure 1, le branchement 20 en amont du compteur 1 et qui alimente une charge 13 constitue une dérivation lorsque les commutateurs 6 et 8 sont inexistants ou fermés et que le commutateur 7 est en circuit ouvert ou qu'il n'y a pas de circuit de contournement 14.
Il sera appelé "contournement avec dérivation" une insertion d'un circuit composé d'au moins deux branchements illégaux, soit un branchement 20 en amont du compteur 1 et un branchement 21 en aval du compteur 1 ou d'une dérivation 22. Dans ce cas, le compteur 1 et la dérivation 22 alimenteront des charges dans diverses proportions de leur apport relatif de courant. L'exemple général illustré à la Figure 1 constitue un contournement avec dérivation lorsque les commutateurs 5, 6, 7 et 8 sont inexistants ou fermés avec les branchement 20, 21 et 22 qui alimentent à la fois les charges 4 et 13. Les résistances de circuit $A_i$ 10, $B_i$ 11, $C_i$ 12 et les résistances des charges $L_i$ 4 et $S_i$ 13 déterminent le ratio du courant mesuré sur le courant subtilisé pour chacune des charges $L_i$ 4 et $S_i$ 13. Il est à noter qu'une subtilisation par déconnexion du neutre est inopérante pour un réseau biphasé (2 x 125 Vac) tel que déployé en Amérique du Nord.

Dans le cadre de cette divulgation, les termes suivants sont utilisés relativement aux mesures de consommation des compteurs. Soit $v_{i,m}$ et $c_{i,m}$ respectivement des moyennes de tension (Volts) et de courant (Ampères) observées à un compteur "$i$" pendant un intervalle d'intégration d'une mesure "$m$". Pour simplifier le texte qui suit, les termes tension et courant pourront, selon le contexte, signifier une moyenne de tension et une moyenne de courant durant un intervalle de temps, notamment un intervalle d'intégration d'une mesure de consommation réalisée par un compteur. Soit $I$ compteurs rattachés à un même transformateur. Il sera appelé échantillon m e {1,$M$} l'ensemble des mesures de tension et courant sur ces $I$ compteurs dans un intervalle de temps à laquelle est associé une estampille temporelle donnée. Selon une réalisation préférée, le courant $c_{i,m}$ du compteur $i$ se calcule à partir des mesures de tension $v_{i,m}$, d'énergie $E_{i,m}$ consommée en kW-h et d'un facteur de puissance $\lambda_{i,m}$ tel que

$$c_{i,m} = \frac{p_{i,m}}{v_{i,m}} \cdot \frac{1}{\lambda_{i,m}} \quad , \tag{1a}$$

où

$$p_{i,m} = E_{i,m} \cdot \frac{3600 \text{ s}}{\Delta t} \cdot \frac{1000 \text{ W-h}}{1 \text{ kW-h}} \tag{1b}$$

est la puissance active et $\Delta t$ est l'intervalle d'intégration exprimé en secondes. Usuellement, lorsque la valeur du facteur de puissance n'est pas disponible, cette valeur est fixée à 1.0 par défaut. Fixer cette valeur à une autre valeur revient à modifier dans une même proportion les estimations réalisées pour les différents compteurs. Le rapport des écarts entre compteurs sur la grandeur qui fait l'objet de l'écart restera inchangé, au premier ordre, si le facteur de puissance est fixé à une autre valeur. Lorsque la valeur instantanée du facteur de puissance n'est pas disponible, les variations temporelles du facteur de puissance s'apparenteront à la présence d'un bruit ajouté à l'estimation du courant (éq. 1a).

Lorsque disponible, une valeur $V_m$ représentative de la tension instantanée au primaire du transformateur peut être utilisée pour normaliser la tension avant le calcul du courant tel que

$$\frac{\sum_{m=1}^{M} V_m}{M \cdot V_m} \tag{1c}$$

remplace la tension instantanée $v_{i,m}$ des compteurs. La valeur représentative peut être une mesure de tension au secondaire du transformateur, peut être calculée d'une mesure de tension sur la ligne moyenne tension (au primaire du transformateur) ou calculée de différentes mesures disponibles sur la ligne. La valeur $V_m$ est validée avant d'être utilisée. La normalisation permet de réduire les "artefacts statistiques" expliqués plus loin.

Dans ce qui suit, l'inexactitude de la mesure d'un capteur de courant d'un compteur est négligée et il est visé de corriger les inexactitudes de la mesure de tension. L'inexactitude de la mesure de tension d'un compteur est principalement le résultat de la somme de trois grandeurs, soit de:

1. l'écart systématique attribué aux composants électroniques et logiciels pour produire la mesure de tension,
2. la dérive lente associée à l'effet de la température sur les composants,
3. la dérive encore plus lente associée au vieillissement des composants.

Un système de mesure d'un compteur peut être constitué d'une électronique analogique reliée à un convertisseur analogique à numérique usuellement du type sigma-delta. Des conditionnements analogiques sont usuellement effectués par des amplificateurs à découpage qui offrent de par leur conception une grande stabilité et exactitude. Le convertisseur calcule un ratio entre une tension à son entrée et une tension de référence pour transmettre une grandeur numérique du ratio en aval du procédé de mesurage. L'erreur systématique attribuable au système de mesure de tension sera donc principalement constituée d'une erreur de coefficient multiplicatif attribuable à l'inexactitude de la tension de référence. Soit

$$V_{i,m} = \left(1 + \alpha_i\right) \cdot v_{i,m} \tag{2}$$

la valeur de tension réelle en fonction de la tension mesurée $v_{i,m}$ où $\alpha_i$ est un coefficient de correction tel que normalement $|\alpha_i| \le 0.002$ pour un Classe 2 (0.2%).

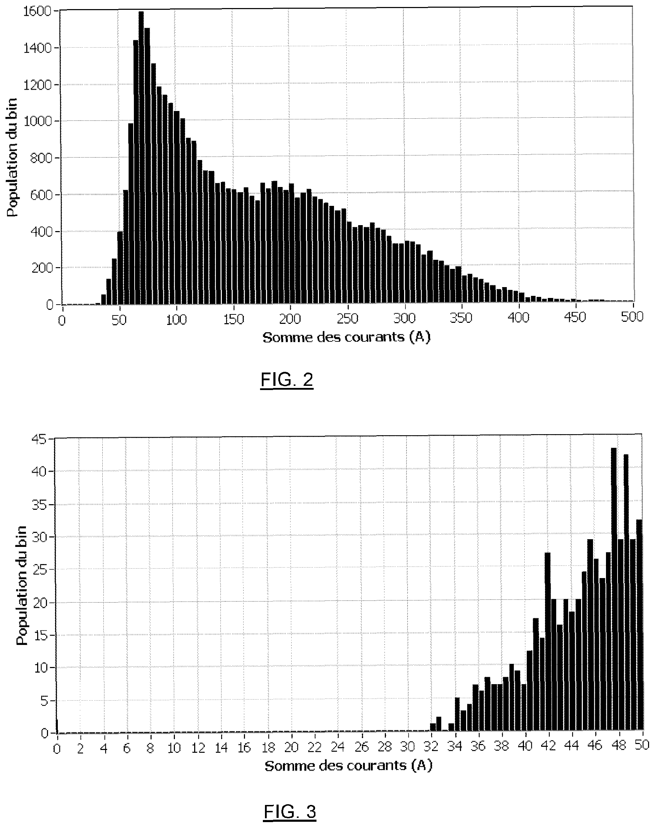

La mesure d'une tension de compteur correspond à la tension de ligne moyenne tension sur le ratio de transformation du transformateur moins la chute de tension attribuable aux courants de charge transitant sur le réseau basse tension. Étant donné que les chutes de tension générées par les courants de charge ne sont pas réparties également entre les compteurs, la tension aux bornes des compteurs est inégale d'un compteur à l'autre. Idéalement, en absence totale de charge, tous les compteurs auraient la même tension à leurs bornes. Une réalisation préférée de la méthode consiste à rechercher une petite fraction des échantillons où la charge totale $\Sigma_i c_{i,m}$ la moins élevée de la cohorte des échantillons disponibles est observée. Dans une réalisation préférée, cette fraction peut être un pourcentage, soit typiquement 1%, ou un nombre, par exemple une centaine d'échantillons, ou le premier de ces seuils qui est atteint. Dans une réalisation préférée, le nombre d'échantillons dont la charge totale ne dépasse pas un seuil donné est dénombré et ce seuil est augmenté itérativement jusqu'à ce que la fraction d'échantillons désirés soit atteinte ou dépassée. Pour l'exemple donné aux Figures 2 et 3, 109 échantillons sont retenus pour un maximum de 43 A.

L'estimation de $\alpha_i$ est d'autant plus précise que le nombre d'échantillons contributifs est grand et que la charge totale est petite. Optimalement, une sélection d'un nombre d'échantillons contributifs peut être effectuée par une analyse d'un histogramme de distribution des charges totales observées. Les échantillons à charges nulles ou trop petites (critères de validation préétablis) sont de préférence écartés dans le calcul car ceux-ci ont une forte probabilité de correspondre à des mesures invalides. Une valeur de charge totale minimale $C_{\min}$ est fixée tel que

$$\sum_i c_{i,m} \ge C_{\min} \tag{3}$$

détermine les échantillons m qui sont éléments de la cohorte retenue. Typiquement, un minimum de 60 W peut être alloué par compteur (pour 240 V), ce qui donne

$$C_{\min} = 0.25 \cdot I \ , \tag{4}$$

soit le produit de 0.25 A par le nombre de compteurs. Par contre, pour établir une cohorte à partir d'une dérivée du courant, on fixe $C_{\min} = 0$ A. De même, une valeur initiale pour le seuil maximal de courant $C_{\max}$ est fixée, soit typiquement

$$C_{\max} = 2.0 \cdot I \ , \tag{5}$$

soit le produit de 2 A par le nombre de compteurs (500 W par client). Enfin, une valeur de $C_{\mathrm{Step}}$ définissant un paramètre d'accroissement discret de $C_{\max}$ dans la boucle itérative est fixée. Plus $C_{\mathrm{Step}}$ est petit, plus l'itération trouvera précisément la valeur de $C_{\max}$ qui donne le nombre désiré d'échantillons et davantage de temps de calcul sera requis. Une valeur de 2 A peut être utilisée par défaut pour $C_{\mathrm{step}}$. Une réalisation préférée de la méthode utilise un vecteur d'état $etat(m)$ tel que

$$etat\left(m\right) = \begin{cases} 1 & \text{si } C_{\min} \le \sum_i c_{i,m} < C_{\max} \\ 0 & \text{autrement} \end{cases} \tag{6}$$

pour signaler si un échantillon est retenu ou non tel que les valeurs $C_{\min}$ et $C_{max}$ sont les extremums de la gamme de charge de la cohorte.

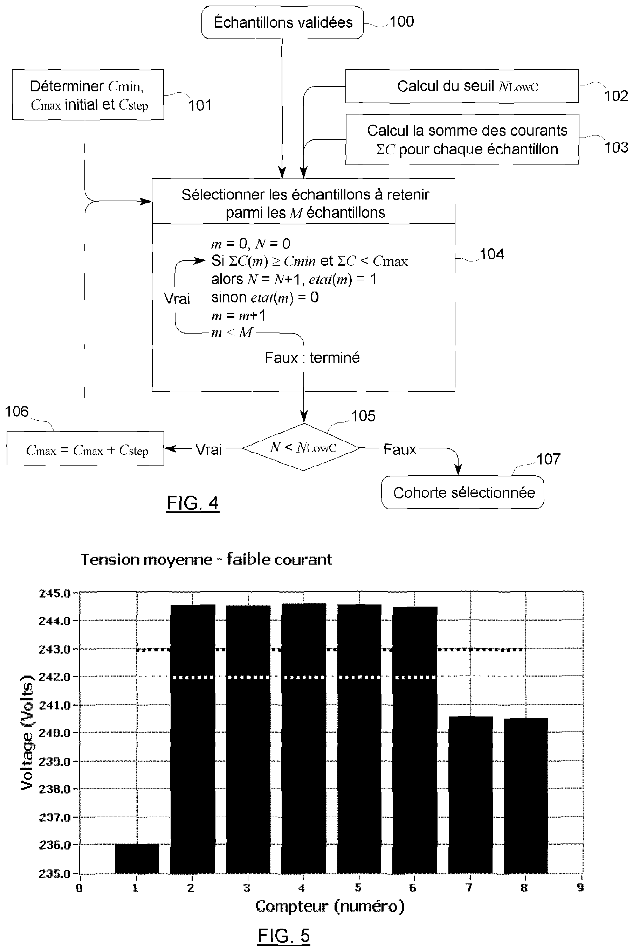

En référence à la Figure 4, pour sélectionner une cohorte d'échantillons retenus comme représenté par le bloc 107 à partir d'échantillons validés comme représenté par le bloc 100, une technique préférée consiste à :

1. établir le seuil $C_{\min}$ , la valeur initiale du seuil $C_{\max}$ et le pas $C_{\mathrm{Step}}$ comme représenté par le bloc 101,
2. calculer le seuil $N_{LowC} = 0.01 \cdot P_{\%LowC} \cdot M$ comme représenté par le bloc 102, exprimé en nombre d'échantillons requis à partir du pourcentage désiré d'échantillons $P_{\%LowC}$ et du nombre total d'échantillons disponibles s,

3. calculer la somme des courants de compteurs pour chaque échantillon comme représenté par le bloc 103,

4. identifier les échantillons pour lesquels $C_{min} \leq \Sigma_i c_{i,m} < C_{max}$, actualiser le vecteur d'état *etat*(*m*) selon l'équation 6 et incrémenter la population *N* de la cohorte des échantillons retenus comme représenté par le bloc 104, et

5. si le nombre d'échantillons identifiés est moindre que le seuil $N_{LowC}$ comme représenté par le bloc 105, alors la valeur de $C_{max}$ s'accroit de la valeur $C_{Step}$ comme représenté par le bloc 106 et l'étape 4 comme représenté par le bloc 104 est répétée, alors que si le nombre d'échantillons cumulés atteint ou dépasse le seuil $N_{LowC}$, alors le processus de sélection est terminé et la cohorte sélectionnée comme représenté par le bloc 107 est disponible comme résultat.

De la sélection obtenue, la tension moyenne par compteur est calculée

$$\overline{v}_i = \frac{1}{m_s} \cdot \sum_{m=1}^{M} v_{i,m} \cdot etat(m) \tag{7a}$$

pour les *I* compteurs et pour l'intervalle de temps défini par les *M* échantillons, avec

$$m_s = \sum_{m=1}^{M} etat(m) \tag{7b}$$

la population des échantillons sélectionnés parmi les *M* échantillons.

Le résultat peut être transmis pour affichage ou autre traitement par exemple pour détecter des anomalies. La tension moyenne d'un compteur peut être comparée avec celle des autres compteurs ou encore avec

$$\overline{v} = \frac{1}{I} \sum_{i=1}^{I} \overline{v}_i \tag{8}$$

la tension moyenne des compteurs tel que $v_{\overline{i}} - \overline{v}$ est défini comme l'écart de tension moyen d'un compteur.

L'écart-type caractérisant la dispersion de la tension instantanée sur chaque compteur pour la cohorte sélectionnée est calculé

$$\sigma_i = \sqrt{\frac{1}{m_s-1}\left( \sum_{m=1}^{M} \left(v_{i,m} - \overline{v}_m\right)^2 \cdot etat(m) - \frac{1}{m_s}\left( \sum_{m=1}^{M} \left(v_{i,m} - \overline{v}_m\right) \cdot etat(m)\right)^2 \right)} \tag{9}$$

en regard de la tension moyenne instantanée

$$\overline{v}_m = \frac{1}{I} \sum_{i=1}^{I} v_{i,m} \tag{10}$$

observée sur l'ensemble des compteurs pour un échantillon *m* donné. Cette valeur d'écart-type est produite pour affichage ou autre traitement afin de déterminer des anomalies. L'écart systématique de tension que peut avoir une mesure de compteur par rapport à la tension moyenne est éliminé dans le calcul proposé à l'équation 9, tel que montré à l'Annexe 1 plus loin.

Selon un calcul de premier ordre, il est proposé d'estimer l'erreur de tension systématique de chaque compteur, de corriger les tensions en conséquence et de reprendre certains calculs. Soit, selon une réalisation préférée,

$$\alpha_i = \sum_m \left(\overline{v}_m - v_{i,m}\right) \cdot etat(m) \Big/ \sum_m v_{i,m} \cdot etat(m) \tag{11}$$

le coefficient de correction de tension à utiliser à l'équation 2. Les valeurs de tensions sont préalablement validées de manière à écarter, selon un critère de validation, celles qui correspondent à des périodes transitoires où, par exemple, une chute de tension dans la période de mesure (ex. 15 minutes) d'un échantillon est observée. La formulation

$$\alpha_i = \frac{1}{m_s} \cdot \sum_m \frac{1}{v_{i,m}} \cdot \left( \overline{v}_m - v_{i,m} \right) \cdot etat(m) \qquad (12)$$

est susceptible d'être moins précisé et robuste. Par exemple, si la tension est perturbée par une anomalie transitoire sur le réseau (ex. une courte panne), en deçà du seuil de rejet de la donnée tension, la division par une plus petite tension amplifiera les écarts apparaissant pour les échantillons correspondant à une anomalie transitoire, ce qui n'est pas souhaitable.

Selon un calcul de second ordre, il est proposé de corriger la chute de tension que chaque compteur a avec la tension moyenne $\overline{v}_m$ en fonction de son courant. Lorsque l'équation 7a est calculée avec les tensions des compteurs, toutes les tensions de compteurs sont affectées par le courant d'un seul compteur. Au second ordre d'approximation, la tension du compteur peut être corrigée en fonction de son courant débité en négligeant les chutes de tension affectant les autres compteurs qui sont générées par ce courant. Il s'agit donc de corriger la chute de tension de chaque compteur entraînée par le courant débité par le même compteur et ce pour la cohorte sélectionnée comme représentée par le bloc 107. Trois choix de résistance sont utilisables pour compenser la chute de tension du courant débité par le compteur i. Il s'agit respectivement de la résistance réseau basse tension, de la résistance de raccordement du compteur à ce réseau et de la résistance totale.

La résistance réseau basse tension vue par le compteur i peut être estimée telle que

$$Z_i = -\frac{\sum_{m=2}^{M} \partial \widehat{v}_{i,m} \cdot \partial c_{i,m}}{\sum_{m=2}^{M} \left( \partial c_{i,m} \right)^2}, \qquad (13)$$

avec la dérivée discrète de tension moyenne instantanée

$$\partial \widehat{v}_{i,m} = \widehat{v}_{i,m} - \widehat{v}_{i,m-1}, \ m > 1, \qquad (14a)$$

et la dérivée discrète de courant

$$\partial c_{i,m} = c_{i,m} - c_{i,m-1}, \ m > 1, \qquad (14b)$$

et où la tension moyenne instantanée

$$\widehat{v}_{i,m} = \left\{ \begin{array}{cc} \displaystyle\sum_{j=1, j \neq i}^{I} v_{j,m} \Big/ \sum_{j=1, j \neq i}^{I} 1 & I > 1 \\ 0 & I = 1 \end{array} \right. \qquad (14c)$$

est telle que la résistance réseau est estimée des chutes de tension observées par les autres compteurs, excluant le compteur ciblé. La formulation donnée à l'équation 13 donne un résultat biaisé par les corrélations entre les courants, biais qui est appelé "aberrations statistiques" dans le cadre de cette divulgation. Cette aberration peut dominer le résultat lorsqu'il y des charges sur minuterie telles que retrouvées pour un éclairage de ville ou pour un espace commun dans un bâtiment commercial ou résidentiel. En effet, une charge sur minuterie génère des créneaux de consommation (ondes carrées) qui, une fois dérivée selon 14a et 14b donne des pics périodiques corrélés avec la variation moyenne de charge journalière sur le réseau. Il s'agit, d'une part, d'exploiter les échantillons et non leurs dérivées, et d'autre part, de considérer l'ensemble des consommations (courants) dans un même calcul afin de ne pas avoir un résultat biaisé par les corrélations entre consommation. Une solution mise en oeuvre consiste à ajuster les valeurs $Z_i$ afin de minimiser le résidu d'écart quadratique

$$residu = \sum_{m=1}^{M}\left(\overline{v}_m + \sum_{i=1}^{I} Z_i \cdot c_{i,m}\right)^2 - \frac{1}{M}\left(\sum_{m=1}^{M}\left(\overline{v}_m + \sum_{i=1}^{I} Z_i \cdot c_{i,m}\right)\right)^2 \qquad (15)$$

où la grandeur

$$\overline{v}_m + \sum_{i=1}^{I} Z_i \cdot c_{i,m}$$

correspond à la tension moyenne instantanée corrigée par les transits de courant. Le recuit simulé peut être une solution pour résoudre l'expression 15. Normalement, les valeurs de résistances réseau devraient être regroupées proche de la faible valeur de la résistance au primaire du transformateur. Lorsque qu'un seul écart significatif est décelé pour la résistance réseau d'un compteur, il s'agit de minimiser l'expression 15 en ajustant seulement la valeur de résistance réseau de ce compteur, les autres valeurs étant fixées par l'expression 13. La normalisation de la tension proposée à l'équation 1c est recommandée dans la mise en oeuvre de la solution de minimisation du résidu. Un raffinement de la technique consiste à appliquer un filtre numérique passe-bande sur les grandeurs électriques de façon à éliminer les variations temporelles lentes correspondant à celles journalières et celles de la réaction de consommation à la température.

La résistance réseau est caractéristique de la position du raccordement d'un compteur sur le réseau. Plus un compteur est raccordé éloigné et plus d'autres compteurs sont raccordés entre lui et le transformateur sur la ligne partageant le même câble basse tension, plus sa résistance réseau sera élevée par rapport aux autres.

Soit

$$y_{i,m} = v_{i,m} + Z_i \cdot c_{i,m} \qquad (16)$$

la tension de lecture du compteur corrigée pour tenir compte de la chute de tension sur la tension moyenne du réseau basse tension entraînée par son courant. La résistance $Z_i$ est comprise ici comme étant la réaction de la tension moyenne à une variation de charge du compteur "i".

La résistance de raccordement du compteur

$$r_i = -\frac{\displaystyle\sum_{m=2}^{M}\left(\partial v_{i,m} - \partial \widehat{v}_{i,m}\right) \cdot \partial c_{i,m}}{\displaystyle\sum_{m=2}^{M}\left(\partial c_{i,m}\right)^2} \qquad (17a)$$

avec la dérivée discrète de tension instantanée

$$\partial v_{i,m} = v_{i,m} - v_{i,m-1} \ , \ m > 1 \qquad (17b)$$

est un facteur représentatif de la résistance de raccordement du compteur "i" traversée par le courant débité par le compteur $i$, estimée à partir de toutes les mesures de tension valides et disponibles sur les compteurs, auquel cas s'écrit

$$y_{i,m} = v_{i,m} + r_i \cdot c_{i,m} \qquad (18a)$$

la série-tension corrigée au compteur $i$. Ajuster la valeur $r_i$ afin de minimiser le résidu d'écart quadratique

$$residu = \frac{\sum_{m=1}^{M}\left(v_{i,m} + r_i \cdot c_{i,m} - \left(\overline{v}_m + \sum_{i=1}^{I} Z_i \cdot c_{i,m}\right)\right)^2 - }{\frac{1}{M}\left(\sum_{m=1}^{M}\left(v_{i,m} + r_i \cdot c_{i,m} - \left(\overline{v}_m + \sum_{i=1}^{I} Z_i \cdot c_{i,m}\right)\right)\right)^2} \qquad (18b)$$

exige plus d'effort de calcul mais permet de réduire les aberrations statistiques. Contrairement à l'expression 15, l'ajustement se fait sur une seule valeur et non pour toutes les valeurs des compteurs simultanément, ce qui exige un effort de calcul moindre.

La résistance

$$R_i = -\frac{\sum_{m=2}^{M} \partial v_{i,m} \cdot \partial c_{i,m}}{\sum_{m=2}^{M} \left(\partial c_{i,m}\right)^2} = r_i + Z_i \qquad (19)$$

est un facteur représentatif de la résistance totale du compteur "$i$" estimée à partir de toutes les mesures valides disponibles, traversée par le courant débité par le compteur $i$, auquel cas s'écrit

$$y_{i,m} = v_{i,m} + R_i \cdot c_{i,m} \qquad (20a)$$

la série-tension corrigée au compteur $i$. Encore ici, pour réduire la contribution d'une aberration statistique, la valeur $R_i$ peut être ajustée afin de minimiser le résidu d'écart quadratique

$$residu = \sum_{m=1}^{M}\left(v_{i,m} + R_i \cdot c_{i,m}\right)^2 - \frac{1}{M}\left(\sum_{m=1}^{M}\left(v_{i,m} + R_i \cdot c_{i,m}\right)\right)^2 \qquad (20b)$$

auquel cas, si la minimisation du résidu a aussi été utilisée pour l'estimation de la résistance de raccordement,

$$Z_i = R_i - r_i \qquad (20c)$$

est alors utilisé afin de calculer, ou de recalculer dans un processus itératif, la résistance réseau sans utiliser l'équation 13 exploitant les dérivées ou l'équation 15 qui peut être exhaustive en effort de calculs.

La série-tension ainsi corrigée peut être introduite dans les équations 7-10 comme il sera vu plus loin. La correction réalisée avec la résistance réseau est usuellement moins importante que celle réalisée avec la résistance apparente de raccordement car la grandeur de la résistance de raccordement est habituellement bien supérieure à la résistance de ligne étant donné le rapport de gabarit des conducteurs. Par contre, dans le cas d'un immeuble locatif où les compteurs sont rattachés à un même distributeur, le raccordement apparaît comme le lien électrique entre un compteur et le distributeur situé dans le bâtiment, soit quelques centimètres de conducteur: la résistance de raccordement apparaît souvent minime dans un tel cas. La correction réalisée avec la résistance totale est souvent la plus importante puisqu'elle est la somme des deux autres. Il est écrit "souvent" car la résistance réseau apparaît parfois négative. Par exemple, lorsque le compteur n'est pas rattaché au même réseau que les autres compteurs, la résistance réseau calculée pour le compteur est proche de zéro ou même négative. Lorsque la résistance réseau est en deçà d'un certain seuil (environ 8 m$\Omega$ pour un réseau aérien), elle est indicatrice d'une erreur de topologie. Lorsqu'il y a un seul compteur, la résistance réseau est nulle puisque $\overline{v}_{i,m} = 0$ (équation 15) et la résistance apparente de raccordement équivaut à la résistance totale. Une technique préférée pour compenser la chute de tension générée par la charge transitée utilise la résistance apparente de raccordement puisqu'il est visé de corriger la tension d'un compteur par rapport à la tension moyenne instantanée. La correction réalisée ne doit pas inclure l'effet de la résistance réseau qui est présente dans les deux autres valeurs de résistance. Cette correction permet de réduire les variations de tension (éq. 7a) ou de dispersion de la tension (éq. 9) générées par les faibles courants observés pour la cohorte d'échantillons sélectionnés. Cependant, dans certains cas, tel celui d'un contournement, la correction peut avoir un effet aveuglant dans la détection d'une NCE. La valeur de résistance $Z_i$, $r_i$ ou $R_i$ est donc bornée par deux valeurs, soit une valeur minimale correspondant à la résistance au primaire d'un transformateur (de 2 à 8 m$\Omega$ selon l'installation) et une valeur maximale qui est fixée typiquement à trois fois la moyenne des résistances observées pour les autres compteurs raccordés au même réseau basse tension que le compteur ciblé. Sur un réseau biphasé, pour une entrée électrique de 200 A et moins, des valeurs de résistance de raccordement qui sont supérieures à 50 m$\Omega$ peuvent correspondre à des NCE puisqu'elles équivalent à une distance de raccordement excédant les 30 m alloués par certaines normes (ex. Norme HQ E.21-10) entre la ligne et le mat sans ajout d'un poteau support, si un conducteur en aluminium de calibre 2 AWG (0.68 m$\Omega$/m à 20°C, multiplié par deux considérant un aller et un retour) est considéré.

Une réalisation préférée pour détecter une erreur de topologie utilise la résistance apparente de réseau. Pour un compteur qui n'est pas relié au réseau traité et qui transite aléatoirement des charges significatives, la résistance réseau est proche de zéro. Les éclairages de ville qui ont une consommation cyclique et les installations qui consomment très peu afficheront une valeur qui pourrait être un artefact statistique sans signification, et ce, que le compteur soit sur le réseau traité ou non. Dans ces derniers cas, il se peut que la résistance réseau ne soit pas suffisante pour déterminer si le compteur est bien relié au réseau traité.

Le calcul des grandeurs de résistance aux équations 13, 17a et 19, peut être réalisé sur un sous-ensemble de données correspondant à la cohorte où le compteur "$i$" présente les dérivées de courant relativement les plus importantes en rapport à la somme quadratique des dérivées de courant des autres compteurs.

La série-tension ainsi corrigée par l'équation 18a peut être introduite dans les équations 7-10 pour réduire le biais créé par les courants transités. L'estimation du coefficient de correction proposé à l'équation 11 devient alors

$$\alpha_i = \sum_m \left( \overline{y}_m - y_{i,m} \right) \cdot etat\left(m\right) \Big/ \sum_m y_{i,m} \cdot etat\left(m\right) \qquad (21)$$

avec

$$\overline{y}_m = \frac{1}{I} \sum_{l=1}^{I} y_{l,m} \qquad (22a)$$

pour tenir compte des chutes de tension par rapport à la tension moyenne observée par l'ensemble des compteurs, la réalisation préférée utilisant $y_{l,m}$ définie par l'expression 18a avec la résistance apparente de raccordement $r_i$ pour la correction de la chute de tension induite par le courant mesuré au compteur. La somme des $\alpha_i$ est nulle pour les expressions données aux équations 11 et 21.

L'estimation de $\alpha_i$ donnée à l'équation 11 ou 21 insérée dans l'équation 2 permet de corriger l'erreur systématique d'écart de tension entre la tension d'un compteur et le groupe de compteurs rattachés au même réseau basse tension. L'erreur systématique commune à tous les compteurs d'un même réseau n'est pas corrigée et reste une inconnue pour les traitements ultérieurs. La méthode minimise l'écart statique et systématique de mesure de tension d'un compteur par rapport à la moyenne des tensions mesurées par les compteurs du même réseau. Ces tensions corrigées peuvent avantageusement être utilisées dans des algorithmes de détection et quantification de NCE pour permettre une comparaison plus précise des mesures électriques et des résultats d'analyse entre compteurs. En métrologie, connaître le biais relatif de tension pour une marque de fabrication donnée de compteur permet d'orienter les actions de certification. Une correction de la consommation peut aussi être appliquée sachant que pour certains types de compteur, la mesure du courant subit le même biais.

Il est à noter que la partie moyenne d'une NCE sera "effacée" par le mécanisme d'étalonnage relatif proposé à l'équation 2 et ne sera plus visible dans la suite des traitements réalisés pour déceler une NCE. Une grandeur excessive du coefficient de correction $\alpha_i$ constitue aussi un indicateur d'une NCE probable. Cet indicateur étant corrélé avec l'écart moyen de tension (éq. 8), un ou l'autre de ces indicateurs pourra être choisi pour signaler une NCE. Dans une réalisation préférée, de la sélection obtenue avec l'éq. 6, la tension moyenne par compteur est calculée en considérant la chute de tension dans le raccordement de chaque compteur tel que

$$\overline{v}_i = \frac{1}{m_s} \cdot \sum_{m=1}^{M} y_{i,m} \cdot etat\left(m\right) \qquad (22b)$$

est l'estimation de la tension moyenne sans charge par compteur.

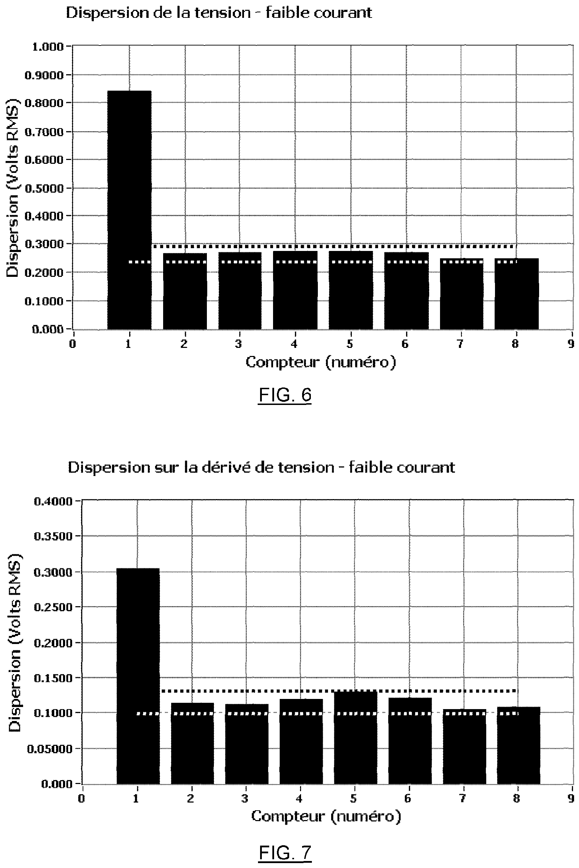

En référence aux Figures 5, 6 et 7, il est présenté un exemple applicatif de dérivation importante d'énergie observable en réseau. Dans l'exemple, le réseau comporte huit compteurs. La Figure 5 est un graphique illustrant une tension moyenne sans charge de chaque compteur, les lignes pointillées correspondant à $\pm 0.2\%$ d'écart par rapport à la tension moyenne de la cohorte. La Figure 6 est un graphique illustrant une dispersion de la tension instantanée observée sur chaque compteur lorsqu'il y a peu de charge transitée sur le réseau, les lignes pointillées correspondant à $\pm 3$ fois l'écart-type des dispersions calculées à partir de la cohorte des échantillons non aberrants (i.e. le compteur #1 est écarté du calcul). La Figure 7 est un graphique illustrant une dispersion de la dérivée de tension instantanée observée sur chaque compteur lorsqu'il y a peu de charge transitée sur le réseau, les lignes pointillées correspondant à $\pm 3$ fois l'écart-type des dispersions calculées à partir de la cohorte des échantillons non aberrants (i.e. le compteur #1 est écarté du calcul). Parmi les huit compteurs de ce réseau, le compteur #1 a une tension nettement plus basse, bien en deçà de 0.2% de la moyenne des tensions moyennes sans charge de tous les compteurs, a une dispersion de la tension instantanée plus de deux fois supérieure aux autres valeurs de dispersion, et a une dispersion de la dérivée de tension instantanée plus de deux fois supérieure aux autres valeurs de dispersion. En référence aux seuils minimal et maximal, le compteur #1 affiche un dépassement franc pour la tension, la dispersion de tension et la dispersion de la dérivée de tension. Sur la Figure 5, une chute de tension importante peut être observée pour les compteurs #7 et #8 qui s'explique du fait que ces compteurs partagent une plus grande portion de câble moyenne tension avec le compteur #1 jusqu'au transformateur.

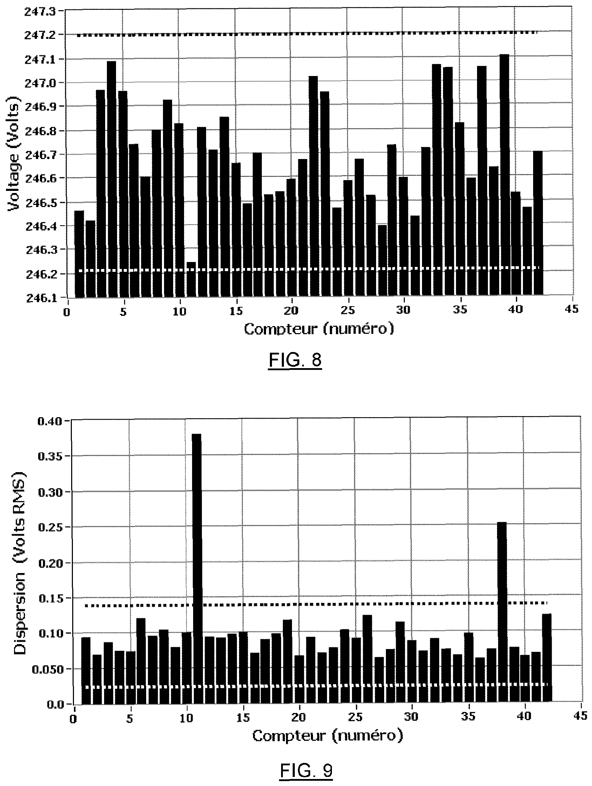

En référence aux Figures 8, 9, 10, 11 et 12, il est présenté un autre exemple applicatif observable en réseau. Dans l'exemple, le réseau est un réseau souterrain comportant 42 compteurs rattachés à un même transformateur. Plusieurs anomalies sont observées sur trois compteurs du réseau souterrain. Les Figures 8 et 9 présentent respectivement la tension moyenne sans charge et la dispersion de la tension instantannée de chaque compteur lorsqu'il y a peu de charge transitée sur le réseau. Sur les Figures 8 et 9, il est illustré des lignes en pointillé exprimant des seuils entre lesquels les valeurs normales sont censées se situer. Pour la Figure 8, ces seuils correspondent à l'écart de précision de la mesure en tension, soit à $\pm 0.2\%$ pour un compteur classe 2 de la tension moyenne de la cohorte. Pour la Figure 9, les seuils correspondent à $\pm 3$ fois l'écart-type des dispersions calculées à partir de la cohorte des échantillons non aberrants, soit ceux qui sont situés à l'intérieur du $\pm 3$ sigma d'un premier calcul de dispersion (i.e. les compteurs #11 et #38 sont écartés du calcul).

Trois anomalies sont détectées à partir de la tension et de la dispersion sur la tension illustrées respectivement aux figures 8 et 9, soient:

- le compteur #11 a une tension proche de la limite du seuil inférieur situé à -0.2% de la tension moyenne sans charge, et une dispersion anormale de sa tension,
- le compteur #38 affiche une dispersion anormale.

Ces anomalies pointent vers une NCE possible (problème de raccordement, point chaud, compteur manquant, compteur en trop non rattaché, subtilisation ou autre), et entre autres, le compteur #11 a été remplacé depuis et le compteur #38 avait un compteur électromécanique à ses côtés. Un contournement constant, soit en l'absence de manipulations des commutateurs 5, 6 et 7 (illustrés à la Figure 1), n'est pas facilement détecté car il génère une baisse minime de la tension et une augmentation peu significative de la dispersion de la tension instantanée. Par contre, pour un contournement avec manipulations, si ces manipulations surviennent dans la cohorte retenue, elles risquent fort d'augmenter la dispersion de la tension instantanée du compteur contourné. Une dérivation aura de bonne chance d'être détectée car le courant transitant par celle-ci n'est pas considéré dans le choix de la cohorte des échantillons sélectionnés. La tension moyenne sera plus basse pour le compteur ou les compteurs partageant le même raccordement que la dérivation et la dispersion sera plus importante pour ces compteurs. La présence d'un compteur électromécanique au côté d'un compteur intelligent aura le même impact qu'une dérivation. Une anomalie de dispersion peut aussi provenir du simple fait que le compteur présentant l'anomalie est un des compteurs qui transite le plus de courant dans la cohorte et ce de façon discontinue. Une comparaison entre la dispersion de la tension instantanée et avec le courant RMS moyen du compteur permet d'écarter ces anomalies. Une correction possible est proposée plus loin pour tenir compte des courants transités dans le calcul de la dispersion de la tension.

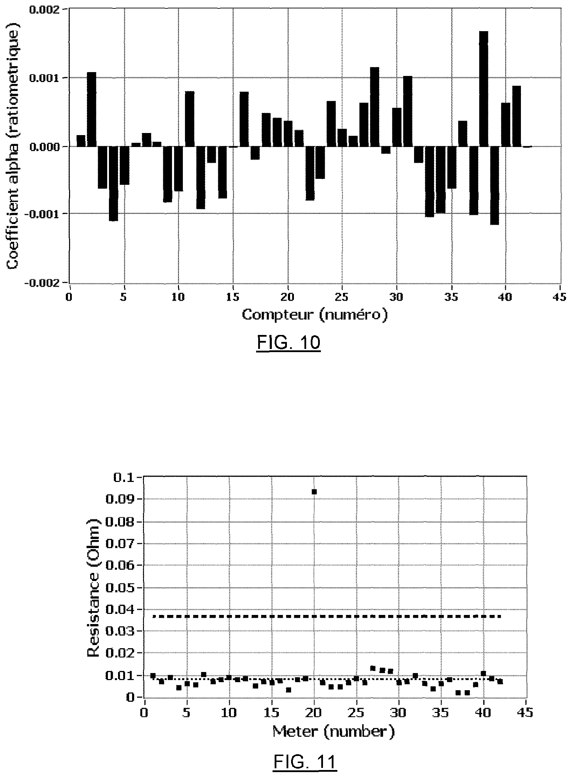

La Figure 10 illustre des valeurs de corrections $\alpha_i$ calculées à partir des mêmes données que celles illustrées aux Figures 8 et 9, les limites de l'échelle verticale du graphique correspondant à la spécification de $\pm 0.2\%$ d'écart sur la mesure de tension. Un écart important de la valeur du coefficient de correction $\alpha_i$ pour un compteur peut signifier une anomalie, le plus souvent un problème topologique où le compteur n'est pas rattaché au bon transformateur. Dans la pratique d'un pays qui a une saison froide, pour des compteurs provenant du même lot de production manufacturière, une stratification des valeurs $\alpha_i$ qui se regroupent en trois lots correspondant respectivement aux compteurs localisés à l'extérieur, aux compteurs localisés dans des garages peu chauffés et aux compteurs localisés dans des pièces chauffées peut être observée en hiver. À la Figure 10, il n'apparait pas d'écart significatif. Par contre, le calcul de la résistance apparente de réseau illustrée à la Figure 11 situe le compteur #20 loin des autres valeurs de résistance apparente. Dans ce dernier exemple, le compteur #20 alimente l'aire commune d'un immeuble de location comprenant 8 logements où les 9 compteurs sont rattachés sur le jeu de barre d'un distributeur situé dans le bâtiment. Dans l'hypothèse d'un contournement, le compteur réalisant le contournement voit la même tension que les autres compteurs faisant en sorte qu'ici, c'est la résistance de réseau qui augmente alors que la résistance de raccordement reste similaire aux autres compteurs.

En ce qui concerne la dispersion des résistances $Z_i$, $r_i$ et $R_i$, les formulations

$$ETYZ_i = \frac{1}{\sum_m \partial c_{i,m}^2} \cdot \sqrt{\frac{1}{M-2} \cdot \left( \sum_{m=2}^{M} \left( \partial \hat{v}_{i,m} \cdot \partial c_{i,m} \right)^2 - \frac{1}{M-1} \left( \sum_{m=2}^{M} \left( \partial \hat{v}_{i,m} \cdot \partial c_{i,m} \right) \right)^2 \right)}, \qquad (23a)$$

$$ETYr_i = \frac{1}{\sum_m \partial c_{i,m}^2} \cdot \sqrt{\frac{1}{M-2} \cdot \left( \sum_{m=2}^{M} \left( \left( \partial v_{i,m} - \partial \hat{v}_{i,m} \right) \cdot \partial c_{i,m} \right)^2 - \frac{1}{M-1} \left( \sum_{m=2}^{M} \left( \left( \partial v_{i,m} - \partial \hat{v}_{i,m} \right) \cdot \partial c_{i,m} \right) \right)^2 \right)}$$

$$(23b)$$

$$ETYR_i = \frac{1}{\sum_m \partial c_{i,m}^2} \cdot \sqrt{\frac{1}{M-2} \cdot \left( \sum_{m=2}^{M} \left( \partial v_{i,m} \cdot \partial c_{i,m} \right)^2 - \frac{1}{M-1} \left( \sum_{m=2}^{M} \left( \partial v_{i,m} \cdot \partial c_{i,m} \right) \right)^2 \right)} \qquad (23c)$$

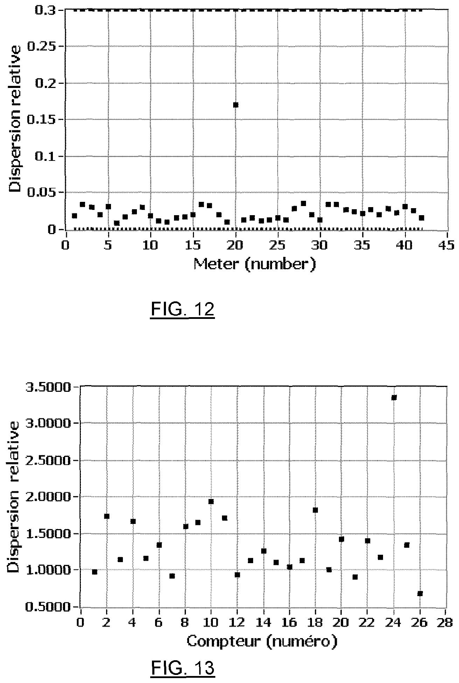

proposent des estimations exploitant le calcul usuel de l'écart-type. La Figure 12 illustre, pour l'exemple donné aux Figures 8-11, la dispersion relative des résistances de raccordement $r_i$. Dans cet exemple, le compteur #6 est celui qui transite le plus de variation de courant sur le réseau et de ce fait, l'estimation de sa résistance réseau affiche la plus faible dispersion. La dispersion élevée de la résistance de raccordement du compteur #20 peut s'expliquer par une aberration statistique ou peut apparaître plus importante que celle des autres compteurs du fait qu'un contournement réduit dans la proportion de son facteur de contournement le rapport de la grandeur du courant mesuré par ce compteur sur le bruit de mesure. Dans le cas du compteur #20, il a été déterminé qu'il s'agit d'une aberration statistique expliquée par la présence d'une minuterie d'éclairage de l'aire commune de pair avec des thermostats électroniques. La formulation proposée à l'équation 15 a permis de corriger cette aberration. La Figure 13 expose un exemple où la dispersion anormale de la résistance réseau du compteur est expliquée par un contournement avec dérivation alternée. En effet, en se reportant à la Figure 1, deux états sont principalement observés, soit avec les commutateurs 5-6-7 dans l'état fermé-ouvert-ouvert ou dans l'état ouvert-fermé-fermé. L'état intermédiaire fermé-fermé-fermé apparaît brièvement dans cet exemple de sorte que la résistance apparente n'est pas significativement augmentée. Par contre, ces manipulations augmentent significativement la dispersion de la résistance apparente comme illustré à la Figure 13.

L'écart-type, donné à l'équation 9, caractérisant la dispersion de la tension instantanée sur chaque compteur par rapport à la tension moyenne instantanée, est amplifié par les courants transités et ce même pour une cohorte comportant de faibles courants.

L'équation 9 peut être réécrite en remplaçant la tension par la tension corrigée (éq. 18a) tel que

$$\sigma_i = \sqrt{\frac{1}{m_s - 1} \left( \sum_{m=1}^{M} \left( y_{i,m} - \bar{y}_m \right)^2 \cdot etat(m) - \frac{1}{m_s} \left( \sum_{m=1}^{M} \left( y_{i,m} - \bar{y}_m \right) \cdot etat(m) \right)^2 \right)} \qquad (24a)$$

où

$$\bar{y}_m = \frac{1}{I} \sum_{i=1}^{I} y_{i,m} \ , \qquad (24b)$$

de sorte que la contribution des chutes de tension dans les raccordements est minimisée. Si un compteur transite une charge cachée, la dispersion de la chute de tension occasionnée par cette variation de charge sera alors plus apparente.

De même, une dispersion de la dérivée en tension instantanée corrigée est calculée

$$\sigma_i = \sqrt{\frac{1}{m_s - 1}\left(\sum_{m=1}^{M}\left(\partial y_{i,m} - \overline{\partial y}_m\right)^2 \cdot etat(m) - \frac{1}{m_s}\left(\sum_{m=1}^{M}\left(\partial y_{i,m} - \overline{\partial y}_m\right)\cdot etat(m)\right)^2\right)} \qquad (25a)$$

où

$$\partial y_{i,m} = \partial v_{i,m} + r_i \cdot \partial c_{i,m} \qquad (25b)$$

est la dérivée tension corrigée et

$$\overline{\partial y}_m = \frac{1}{I}\sum_{i=1}^{I}\partial y_{i,m} \qquad (25c)$$

est la valeur moyenne de la dérivée tension. Le retrait de la valeur moyenne de dérivée est réalisé du fait que cette moyenne reste significative pour une cohorte d'un nombre fini d'échantillons.

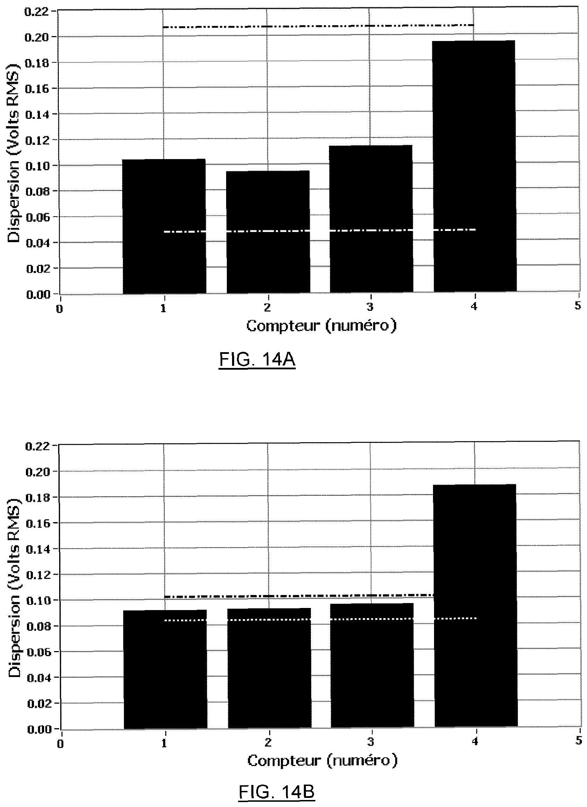

En référence aux Figures 14A et 14B, il est illustré un exemple de correction de chute de tension effectué pour un réseau basse tension comprenant quatre compteurs. Dans cet exemple, le premier et le troisième compteur transitent plus de variations de charge que les deux autres. Comme illustré à la Figure 14B, la correction de chute de tension abaisse la dispersion des trois premiers compteurs vers une valeur commune alors que le quatrième compteur reste avec une valeur de dispersion bien plus grande que les autres. Une NCE peut être suspectée pour ce quatrième compteur. Dans d'autres cas observables, ce qui peut paraître un dépassement du seuil d'anomalie retourne sous le seuil suite à la correction de chute de tension. Dans l'exemple, les seuils d'anomalie sont déterminés selon un multiple de l'écart-type des valeurs observées. Cependant, pour la Figure 14B, la valeur du quatrième compteur est considérée comme une donnée aberrante et est écartée du calcul des seuils et c'est pourquoi la valeur des seuils change dramatiquement ici avec la correction de la chute de tension.

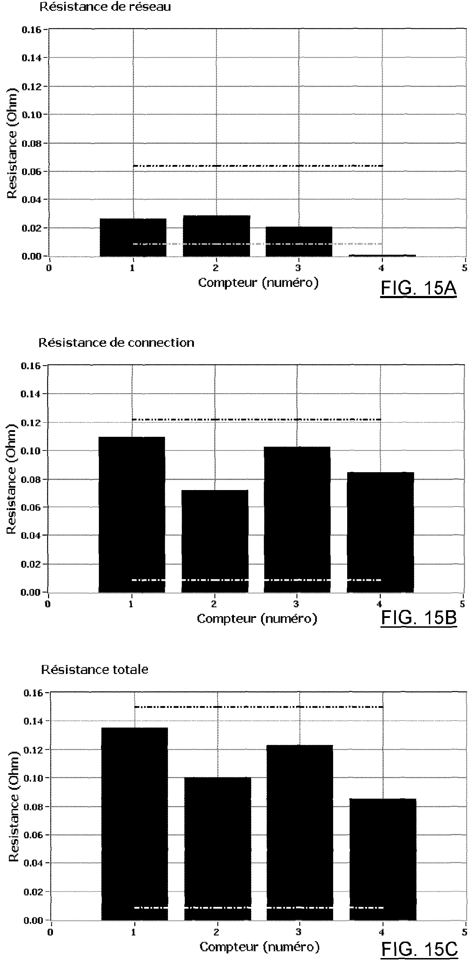

Les Figure 15A, 15B et 15C reprennent le même cas que les Figures 14A et 14B pour illustrer la différence entre les divers types de résistance apparente. Ici, pour le quatrième compteur, la résistance totale et la résistance de connexion apparaissent normales alors que la résistance réseau est proche de zéro, bien en deçà du seuil de 80 mΩ. Les autres compteurs ne perçoivent pas les commutations de charge du quatrième compteur. Le verdict est une NCE d'erreur d'appariement compteur-transformateur. En d'autres mots, le quatrième compteur n'est pas sur ce réseau. Cet exemple démontre l'utilité de séparer la résistance totale en deux valeurs résistives distinctes, soit la résistance réseau et la résistance de raccordement. Si la méthode implique de disposer au préalable d'un appariement compteur-transformateur du réseau basse tension, par contre, une erreur de topologie est détectable comme lorsqu'un compteur évalué n'est pas rattaché aux autres compteurs participants au calcul de tension moyenne et donne une valeur résistive aberrante.

Un luminaire avec des commutations synchronisées de façon journalière avec des pointes de consommation peut générer une aberration statistique jusqu'à l'obtention d'une résistance apparente négative. Dans une réalisation préférée, un profil (patron temporel) particulier des éclairages de ville est reconnu de sorte que les compteurs correspondants sont traités différemment (ex. minimisation d'un résidu quadratique) et surtout écartés du traitement diagnostic des NCE.

En référence à nouveau à la Figure 1 et aux explications attenantes sur le contournement, si le client active selon un patron constant les commutations de contournement, cette manipulation générera des inconsistances et des aberrations significatives de ses valeurs d'estimation de la résistance réseau, de la résistance de raccordement et de la résistance totale. Selon le patron choisi, la régularité de son exécution et sa corrélation avec les pointes de consommation, les dispersions relatives *ETYZ, ETYr* et *ETYR* calculées pour ce client peuvent se distinguer significativement des autres calculs de dispersion. Un obstacle à l'utilisation de la dispersion de la résistance est de distinguer entre les compteurs transitant peu de courant et les contournements. Les deux afficheront peu de courant transité et une dispersion importante. Si les commutateurs 5, 6 et 7 de contournement sont activés saisonnièrement, il est alors possible d'observer une grande dispersion et même plus d'une valeur distincte de résistance apparente selon le patron (position des commutateurs et moment d'activation) saisonnier opéré. De même, si ces commutateurs sont activés selon un patron journalier, il est alors possible d'observer un patron journalier dans la valeur de la résistance et dans la valeur de la dispersion de cette résistance. Pour déterminer le patron journalier, il est possible, par exemple, de regrouper ("binner") par tranche horaire les données disponibles, les traiter et les afficher en 12 ou 24 blocs distincts.

La valeur maximale du courant

$$C_m = \max \left\{ c_{1,m}, c_{2,m}, \ldots, c_{i,m} \right\} \tag{26}$$

observée sur les compteurs pour un échantillon $m$ peut se substituer à la somme des courants réalisé à l'étape 104 (illustrée à la Figure 4) et se substituer au résultat correspondant dans l'équation 3 de sorte que

$$etat(m) = \begin{cases} 1 & \text{si } C_{\min} \le C_m < C_{\max} \\ 0 & \text{autrement} \end{cases} \tag{27}$$

remplace l'équation 6. Ces deux variantes présentent des résultats similaires et dépendamment du cas de subtilisation, la somme des courants ou le maximum de courant peut selon le cas présenter une meilleure sensibilité.

Dans le cas d'un réseau qui comprend des producteurs d'énergie avec des compteurs prévus à cet effet, ce sont les valeurs absolues des valeurs discrètes de courant qui sont prises en compte dans la somme des courants aux équations 3 et 6 ainsi que dans l'argument max{} de l'équation 26.

Pour la détection de subtilisation, une technique avantageuse consiste à remplacer le courant $c_{i,m}$ et la tension $v_{i,m}$ par leur dérivée discrète respective. Soit la série temporelle des dérivées discrètes sur le courant

$$\partial c_{i,m} = c_{i,m} - c_{i,m-1} \tag{28}$$

et la série temporelle des dérivées discrètes sur la tension

$$\partial v_{i,m} = v_{i,m} - v_{i,m-1} \tag{29}$$

auquel cas la somme des courants dans l'équation 3 est remplacée par

$$\sum_i f\left(\partial c_{i,m}\right), \tag{30}$$

soit la somme d'une fonction des dérivées discrètes sur le courant ou, selon la technique proposée à l'équation 26, cette somme est remplacée par

$$C_m = \max \left\{ f\left(\partial c_{1,m}\right), f\left(\partial c_{2,m}\right), \ldots, f\left(\partial c_{I,m}\right) \right\}, \tag{31}$$

soit le maximum d'une fonction de la variation de courant observée sur les compteurs pour l'échantillon $m$. Typiquement, la fonction $f(\ )$ est la valeur absolue

$$f\left(\partial c_{i,m}\right) = \left| \partial c_{i,m} \right| \tag{32a}$$

ou le carré

$$f\left(\partial c_{i,m}\right) = \left(\partial c_{i,m}\right)^2. \tag{32b}$$

Pour ces deux exemples de fonction, le seuil minimal de courant $C_{\min}$ est fixé à zéro, et le seuil $C_{max}$ et le pas $C_{step}$ sont ajustés en conséquence. Les déterminations des moyennes et des écarts proposées aux équations 7a et 9 peuvent être réalisées sur la tension ou la dérivée de la tension (éq. 29) à partir de la cohorte déterminée selon une des techniques précédentes. Préférentiellement, les tensions sont observées en fonction d'une cohorte minimisant les courants et les variations de tension en fonction d'une cohorte minimisant les variations de courant.

Un cas intéressant de subtilisation d'énergie consiste à alterner une charge de la consommation légale à une dérivation raccordée en amont du compteur tel que détaillé au Tableau 1.

| Tableau 1 (en référence à la Figure 1) | | | |
| --- | --- | --- | --- |
| Exemple d'états de commutation opérés dans certaines techniques de subtilisation qui consistent à déplacer une charge de la consommation légale à une dérivation. | | | |
| | Commutateur 6 | Commutateur 7 | Commutateur 8 |
| Charge $S_i$ 13 en consommation légale | ouvert | fermé | fermé |
| Charge $S_i$ 13 en dérivation | fermé | ouvert | fermé |

Deux charges similaires, l'une alimentée par le circuit du compteur et l'autre par le circuit de la dérivation, opérées de sorte que soit l'une, soit l'autre charge soit alimentée, donne le même résultat qu'une même charge commutée de l'un à l'autre des circuits. Cette manipulation permet d'abaisser la résistance apparente puisque pour une portion de la charge, soit la charge commutée, il n'y a pas de variation de tension observée au compteur. Entre autres, une telle manipulation permet de cacher un contournement lorsqu'une méthode de détection comme celle proposée dans US 2015/0241488 (Sonderegger) est utilisée. En effet, bien opérée, cette manipulation n'ajoute pas à la dispersion de la mesure de résistance totale et abaisse adéquatement la valeur de cette résistance. Pour détecter cette manipulation, il s'agit de compter les fois où il y a eu une petite variation de tension en contrepartie d'une grande variation de courant transité par le compteur. Un problème est que le compteur n'est pas seul et qu'il faut rechercher les occasions où il y a eu des variations importantes de courant seulement pour le compteur observé. Pour ce faire, une réalisation préférée remplace le courant de la somme des compteurs par une autre grandeur qui, par exemple, peut être un rapport entre la somme des dérivées discrètes de courant des autres compteurs sur la dérivée discrète du courant du compteur ciblé par la détection. Dans une réalisation préférée, pour la détection de ce type de manipulation, le vecteur d'état s'écrit

$$etat_i\left(m\right)=\begin{cases}1 & \text{si } D_{\min}\le d_{i,m}<D_{\max}\\0 & \text{autrement}\end{cases} \tag{33}$$

pour déterminer les échantillons retenus pour les traitements ultérieurs de sorte que les valeurs $C_{\min}$ et $C_{max}$ définissent des extremums de la gamme de ratio de variation de charge de la cohorte. Un vecteur d'état est calculé (une cohorte déterminée) pour chaque compteur. Dans la réalisation préférée, la grandeur

$$d_{i,m}=\frac{\sum_{j\ne i}g\left(c_{j,m}\right)}{g\left(c_{i,m}\right)+\varepsilon_i} \ , \ g\left(c_{j,m}\right)\equiv\partial c_{j,m}^2 \tag{34}$$

est définie avec

$$\varepsilon_i=\varepsilon\cdot\frac{1}{M}\cdot\sum_{m=0}^{M-1}g\left(c_{i,m}\right) \tag{35}$$

une valeur positive infinitésimale permettant d'éviter des divisions par zéro et pour laquelle $\varepsilon= 10^{-5}$ typiquement. Utiliser plutôt $g(c_{j,m})\equiv|\partial c_{j,m}|$ peut donner des résultats très rapprochés de la réalisation préférée mais moins précis en moyenne sur un grand nombre de cas. La grandeur $D_{min}$ est fixée de préférence à zéro alors que la valeur $D_{max}$ est fixée pour obtenir le nombre désiré d'échantillons retenus. Lorsque le compteur ciblé est contourné partiellement, il transite peu de courant faisant en sorte que la valeur $D_{max}$ est alors fixée bien plus haute que pour les autres compteurs.

La cohorte déterminée avec l'équation 33 correspond aux moments où le compteur ciblé commute les charges les plus importantes en rapport aux charges commutées par les autres compteurs. Cette cohorte est utilisée pour le calcul des résistances et dispersion sur la résistance dont les résultats sont comparés aux mêmes estimations faites pour une autre cohorte, par exemple l'ensemble des échantillons disponibles. Si les estimations obtenues avec la cohorte déterminée avec l'équation 33 donnent une valeur de résistance moindre et une dispersion accrue (exemple de critères de comparaison), c'est qu'il y a vraisemblablement une alternance de charges entre le compteur ciblé et une dérivation. Une réalisation préférée pour détecter ce type de manipulation est un comptage des valeurs de -8v/8c apparaissant sous un seuil minimal, voire même négatives, pour une variation de courant $\delta c$ fixée à une grandeur minimale (ex. 10 ou 15 A) afin d'éliminer les fluctuations normales de la tension et n'observer que les écarts de tension associées à de grandes commutations de courant. Dans une réalisation préférée, un seuil de compte est fixé à 10 pour une cohorte d'échantillons répartis sur une année. Parmi les fluctuations de tension qui sont perçues comme du bruit, rappelons qu'une variation de facteur de puissance d'une charge importante créée une telle fluctuation. Certains compteurs où une charge occasionnelle réactive est opérée présenteront des fluctuations de tension plus importantes. Il peut être avantageux de calculer la dérivée de tension et la dérivée de courant pour trois échantillons temporels contiguës au lieu de deux car une commutation de charge survient selon une densité uniforme dans l'intervalle de mesurage d'un échantillon (ex. 15 minutes). Il s'agit de considérer la différence entre l'échantillon après et l'échantillon situé avant l'échantillon où survient une commutation.

Le tableau 2 qui suit résume les liens entre anomalies électriques et leur impact sur les indicateurs déterminés par la méthode selon l'invention. La subtilisation mixte/alternée fait référence au contournement avec dérivation où des manipulations ont cours durant la période de collecte des échantillons. Une subtilisation mixte/alternée a plusieurs symptômes en commun avec une erreur de topologie. Un compteur qui partage un raccordement avec un compteur électromécanique affichera les mêmes symptômes qu'une dérivation puisque la variation de charge du compteur électromécanique entraînera une variation de tension proportionnelle à la résistance de raccordement. Un défaut de raccordement se situe entre le branchement sur le réseau basse tension et l'embase du compteur alors qu'un point chaud est un défaut localisé dans l'embase supportant le compteur embrochable. Ces deux défauts sont similaires et apparaissent comme une variation de résistance de raccordement accompagné d'une chute de tension de sorte qu'il est difficile de distinguer entre ces derniers à partir des mesures électriques seules. De toute façon, que ce soit un ou l'autre défaut, une investigation sur place pourra permettre d'en trouver la source.

| Tableau 2 | | | | | |
| Lien couramment observé entre un indicateur déterminé par la méthode et une anomalie électrique | | | | | |
| **Indicateur** | **Subtilisations** | | | **Raccordement défectueux Point chaud** | **Erreur de topologie** |
| | Contournement constant | Dérivation | Mixte/ Alterné | | |
| Tension moyenne (éq. 7a) | - à faible ↓ | ↓ | A | ↓ | A |
| Dispersion Tension instantanée (éq. 9) | - | ↑↑ | ↑ | ↑ | ↑↑ |
| $\alpha_i$ (éq. 11) | - à faible ↑ | ↑ | ↑ | ↑ | A |
| Résistance réseau $Z_i$ (éq. 13) | ↑ à ↑↑ | - | A | - | ↓↓↓ ≈0 |
| Dispersion de $Z_i$ (éq. 23a) | - | ↑ | ↑ | ↑↑ | ↑ |
| Résistance raccordement $r_i$ (éq. 17a) | T à TTT | - | A | ↑ à ↑↑↑ par épisodes | A |
| Dispersion de $r_i$ (éq. 23b) | - | ↑ | ↑ | ↑↑ | ↑ |
| Compte des dépassements $\delta v / \delta c$ | - | - | ↑↑↑ | - | - |
| -: sans ou avec peu d'impact<br>A: aléatoire ou aberrant | | | ↑: augmentation ou écart positif<br>↓: réduction ou écart négatif | | |

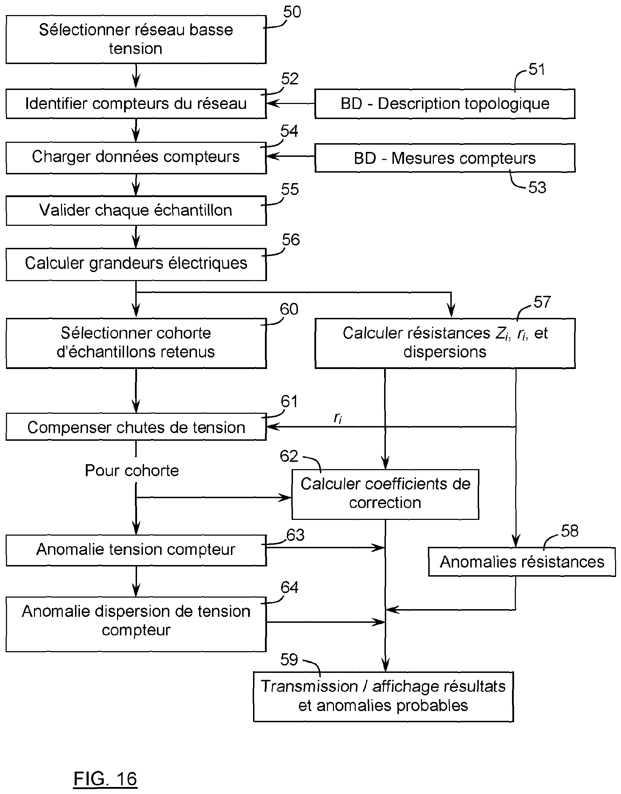

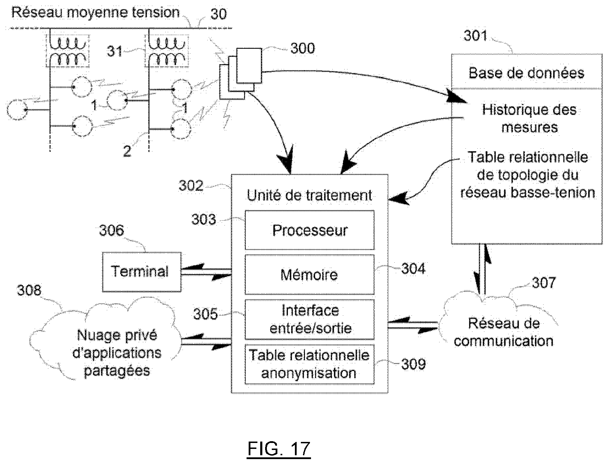

En référence à la Figure 16, il est illustré une réalisation préférée de la méthode selon l'invention. Comme représenté par le bloc 50, la méthode démarre avec la sélection d'un réseau de basse tension réalisée manuellement ou automatiquement. Comme représenté par le bloc 51, la base de données 301 (illustrée à la Figure 17) contenant un descriptif topologique du réseau est interrogée pour, comme représenté par le bloc 52, identifier les compteurs rattachés au réseau sélectionné. Comme représenté par le bloc 53, de ces compteurs identifiés, la base de données 301 contenant un historique des mesures des compteurs est interrogée pour, comme représenté par le bloc 54, charger en mémoire 304 (illustrée à la Figure 17) les mesures/données des compteurs rattachés au réseau sélectionné. Comme représenté par le bloc 55, une étape de valider chaque échantillon utilise la mesure de tension pour détecter des pannes de courant et écarter les échantillons correspondants et avoisinants aux pannes, le résultat conservé à l'issue du rejet de certains candidats étant les échantillons validés 100 (tel qu'illustré à la Figure 4). Les échantillons correspondants à des données aberrantes, telles celles qui donnent des valeurs de tension ou courant hors spécifications, peuvent aussi être écartés des traitements ultérieurs à l'étape 55. Comme représenté par le bloc 56, pour chaque échantillon, il s'agit de calculer des grandeurs électriques comme le courant de chaque compteur, la somme des courants des compteurs, les variations de tension et de courant avec l'échantillon précédent, et la tension moyenne. Ces calculs peuvent être réalisés d'un bloc à l'étape 56 ou, pour certains de ces calculs, plus loin, avant que le résultat ne soit requis dans un calcul ultérieur. Comme représenté par le bloc 57, un calcul de la résistance réseau et de la résistance de raccordement de chaque compteur et de leur dispersion s'effectue (éq. 13, 17a, 23a, 23b) à partir de l'ensemble de données disponibles ou d'un sous-ensemble. Comme représenté par le bloc 58, des anomalies de résistance et de dispersion de la résistance sont détectés pour la résistance réseau et la résistance de raccordement. À cette étape, un dépassement d'un seuil basé sur l'écart-type et la moyenne de la cohorte des valeurs constitue un des échantillons plausibles. Une technique préférée pour contrôler la valeur de la résistance réseau est de fixer la valeur minimale de résistance réseau à celle mesurée au secondaire du transformateur basse tension et la valeur maximale à "x" fois celle observée en moyenne sur le réseau ciblé ou sur les réseaux avoisinants. Une technique préférée pour contrôler la valeur de la résistance de raccordement est de fixer la valeur minimale de résistance de raccordement à zéro et la valeur maximale à 50 m$\Omega$. Comme représenté par le bloc 58, les compteurs qui affichent des anomalies de la valeur ou de la dispersion sur la valeur de leur résistance réseau ou de leur résistance de raccordement sont identifiés et, comme représenté par le bloc 59, signalés. Comme représenté par le bloc 60, l'étape de sélectionner une cohorte des échantillons correspondant à une faible charge transitée par le réseau constitue un aspect particulier de la méthode. Une réalisation préférée de l'étape 60 est détaillée à la Figure 4 et a pour résultat une cohorte d'échantillons retenus comme représenté par le bloc 107. Comme représenté par le bloc 61, une étape de compenser les chutes de tension générées par les faibles charges transitées constitue une correction de second ordre optionnelle qui permet de compenser pour la chute de tension dans le raccordement de chaque compteur en fonction de sa résistance de raccordement et de sa charge transitée. Comme représenté par le bloc 62, un calcul des coefficients de correction $\alpha_i$ est effectué à partir des échantillons de la cohorte sélectionnés au bloc 61 et ce avec (éq. 21) ou sans (éq. 11) la correction de tension déduite de la résistance de raccordement (éq. 17a) calculée au bloc 57 et du courant. Les mesures de consommation peuvent ainsi être adaptées par l'entremise des étapes 61 et 62. Les valeurs $\alpha_i$ sont acheminées vers l'étape 59 de transmission / affichage des résultats et anomalies probables. Comme représenté par les blocs 63 et 64, de même, les anomalies de tension compteur et de dispersion de tension compteur détectées sont acheminées vers l'étape 59. Les anomalies de tension (bloc 63) peuvent être détectées par des opérations impliquant de calculer une tension moyenne par compteur, calculer des seuils correspondant aux écarts de précision de la mesure en tension, et chercher les compteurs qui ont leur tension moyenne située à l'extérieur des seuils de précision. Les anomalies de dispersion de tension (bloc 64) peuvent être détectées par des opérations impliquant de calculer la dispersion de la tension instantanée observée sur chaque compteur, calculer la dispersion sur cette dispersion, et chercher les compteurs qui ont leur dispersion de tension anormalement distant de la cohorte.

En référence à la Figure 17, il est illustré un système pouvant réaliser la méthode selon l'invention. Selon un arrangement physique de connectivité destiné à exécuter la méthode, un réseau de communication 300 reçoit des mesures de consommation de compteurs intelligents 1 rattachés à un réseau basse tension 2 lui-même rattaché à une ligne moyenne tension 30 par un transformateur 31. Le réseau de communication 300 peut comprendre des équipements de communication pouvant disposer d'une mémoire contenant temporairement les données des mesures compteur à transmettre. Une unité de traitement 302, comprenant un processeur 303, une mémoire 304, une interface entrée/sortie 305 et une table relationnelle pour anonymisation de données 309 reçoit les données de tension compteur du réseau de communication 300 ou d'une base de données 301 pouvant contenir des historiques de mesures compteur et des tables relationnelles qui décrivent une topologie du réseau. Des instructions décrivant des opérations à exécuter par le processeur 303 pour réaliser la méthode selon l'invention peuvent être chargées dans la mémoire 304 de l'unité de traitement 302. L'historique des tensions contenu dans la base de données 301 peut avoir été généré et déposé dans celle-ci par le réseau 300 et/ou par l'unité de traitement 302. L'unité de traitement 302 peut être configurée par un terminal 306 connecté à celle-ci ou par un autre équipement via un réseau de communication 307 connecté à l'interface entrée/sortie 305. La méthode peut être démarrée manuellement par un utilisateur par exemple au moyen du terminal 306 ou par une configuration qui comprend entre autres un intervalle entre deux exécutions automatiques de la méthode. D'autres applications peuvent au travers du réseau de communication 307 consulter ou modifier la base de données 301, et plus particulièrement les tables relationnelles contenues dans celle-ci 301. D'autres applications peuvent configurer l'unité de traitement 302 au travers du réseau de communication 307 relié à l'interface entrée/sortie 305 par exemple pour fixer certains réglages ou utiliser des fonctions programmées utiles à la méthode selon l'invention.

L'unité de traitement 302 peut débuter l'application/exécution des étapes préférées de la méthode comme détaillées à la Figure 16 par la sélection d'un réseau basse tension à contrôler et la quête des historiques compteurs afférents au réseau sélectionné. La suite du traitement peut être réalisée dans l'unité de traitement 302 ou dans un nuage privé d'applications partagées 308 contenant des instructions pour réaliser la méthode ou une partie de la méthode. Dans ce dernier cas, les données transmises de l'unité de traitement 302 dans le nuage privé 308 sont de préférence anonymisées, par exemple en créant une table relationnelle 309 faisant un lien entre des identifiants clients et un identifiant anonyme des compteurs 1 de même que pour un identifiant du réseau basse tension 2 et pour un identifiant du réseau moyenne tension 30. Les résultats de la méthode peuvent être utilisés par d'autres méthodes ou applications déployées dans l'unité de traitement 302 ou dans le nuage privé 308, ou transmis pour affichage au terminal 306 ou transmis à tout autre système relié via le réseau de communication 307. L'affichage au terminal 306 ou sur un autre dispositif peut prendre la forme de représentations graphiques semblables à celles illustrées aux Figures 2, 3, 5, 6, 7, 8, 9, 10, 11, 12, 13, 14A, 14B, 15A, 15B et 15C permettant de voir les résultats de la méthode et détecter des NCE.

Quoique la méthode selon l'invention décrite ci-dessus réfère à plusieurs équations, il doit être compris que les équations en question décrivent et définissent des algorithmes ou des formes d'algorithmes qui, lorsqu'implémentées dans et par un ordinateur ou un système informatique, constituent une forme concrète de réalisation de l'invention. Bien que des réalisations de l'invention aient été illustrées dans les dessins ci-joints et décrites ci-dessus, il apparaîtra évident pour les personnes versées dans l'art que des modifications peuvent être apportées à ces réalisations sans s'écarter de l'invention.

**Annexe 1** - Démonstration qu'un écart systématique de tension "e" est éliminé dans le calcul proposé à l'équation 9.

$$\sum_{m=1}^{M}\left(e+v_{i,m}-\overline{v}_m\right)^2 - \frac{1}{M}\left(\sum_{m=1}^{M}\left(e+v_{i,m}-\overline{v}_m\right)\right)^2$$

$$\sum_{m=1}^{M}\left(\left(v_{i,m}-\overline{v}_m\right)^2 + 2e\cdot\left(v_{i,m}-\overline{v}_m\right)+e^2\right) - \frac{1}{M}\left(M\cdot e+\sum_{m=1}^{M}\left(v_{i,m}-\overline{v}_m\right)\right)^2$$

Puisque

$$\overline{v}_i = \frac{1}{M}\cdot\sum_{m=1}^{M} v_{i,m}$$

Donc

$$\sum_{m=1}^{M}\left(v_{i,m}-\overline{v}_m\right)^2 + 2M\cdot e\overline{v}_i - 2M\cdot e\overline{v}_m + M\cdot e^2 - M\cdot e^2 - 2e\sum_{m=1}^{M}\left(v_{i,m}-\overline{v}_m\right) - \frac{1}{M}\left(\sum_{m=1}^{M}\left(v_{i,m}-\overline{v}_m\right)\right)^2$$

$$\sum_{m=1}^{M}\left(v_{i,m}-\overline{v}_m\right)^2 + 2M\cdot e\overline{v}_i - 2M\cdot e\overline{v}_m - 2M\cdot e\overline{v}_i + 2M\cdot e\overline{v}_m - \frac{1}{M}\left(\sum_{m=1}^{M}\left(v_{i,m}-\overline{v}_m\right)\right)^2$$

$$\sum_{m=1}^{M}\left(v_{i,m}-\overline{v}_m\right)^2 - \frac{1}{M}\left(\sum_{m=1}^{M}\left(v_{i,m}-\overline{v}_m\right)\right)^2$$

## Revendications

1. Méthode de correction, par un processeur (303) avec une mémoire (304), de mesures de consommation prises à intervalles temporels par un ensemble de compteurs (1) présumés être rattachés à un même réseau (2), la méthode comprenant les étapes de:

   (i) collecter (53, 54) les mesures de consommation et les mettre dans la mémoire (304) sous forme d'un ensemble d'échantillons classés temporellement selon les intervalles temporels de prises des mesures de consommation par les compteurs;
   (ii) valider (55), par le processeur (303), les échantillons en mémoire selon des critères de validation préétablis;
   (iii) déterminer (56), par le processeur, des grandeurs électriques en relation avec des courants et des tensions se rapportant respectivement aux compteurs pour chaque intervalle temporel à partir des échantillons considérés valides;

(iv) sélectionner (60), par le processeur, une cohorte d'échantillons retenus (107) parmi les échantillons considérés valides, qui correspondent à une gamme de charge ou une gamme de ratio de variation de charge transitée par le réseau basée sur les grandeurs électriques déterminées en (iii);

(v) définir (62), par le processeur, des fonctions de correction des mesures de consommation en déterminant, pour chaque compteur, à partir de la cohorte d'échantillons retenus (107) sélectionnée en (iv), un coefficient de correction de tension applicable à une tension mesurée par le compteur d'après les mesures de consommation du compteur, le coefficient de correction de tension correspondant à une somme de différences de tension entre une tension moyenne sur l'ensemble des compteurs (1) et la tension du compteur, ladite somme étant divisée par la somme desdites tensions du compteur; et

(vi) adapter, par le processeur, les mesures de consommation selon les coefficients de correction définis en (v).

2. La méthode selon la revendication 1, dans laquelle la gamme de charge est déterminée par rapport à un pourcentage ou un nombre d'échantillons requis pour former la cohorte d'échantillons retenus (107).

3. La méthode selon la revendication 2, comprenant de plus les étapes de dénombrer un ensemble d'échantillons considérés valides dont une charge totale est inférieure ou égale à un seuil prédéfini, et augmenter itérativement le seuil jusqu'à ce que le pourcentage ou le nombre d'échantillons soit atteint ou dépassé.

4. La méthode selon la revendication 1, dans laquelle les fonctions de correction comprennent des corrections de chutes de tensions générées par des courants de charges transités par les compteurs (1).

5. La méthode selon la revendication 4, dans laquelle les corrections de chutes de tensions comprennent des calculs de grandeurs de résistance réseau vue par chaque compteur ou de résistance de raccordements de chaque compteur au réseau, ou de résistance totale pour chaque compteur.

6. La méthode selon la revendication 5, comprenant de plus l'étape de détecter une non-conformité électrique relative à un compteur ciblé parmi les compteurs (1) lorsqu'une des grandeurs des résistances calculées pour le compteur ciblé est en deçà d'un seuil minimal prédéterminé ou au-delà d'un seuil maximal prédéterminé, ou qu'une dispersion des grandeurs d'une des résistances du compteur ciblé excède un seuil prédéterminé.

7. La méthode selon la revendication 5, dans laquelle la grandeur de résistance réseau vue par un compteur ciblé parmi les compteurs (1) est estimée en fonction de grandeurs en relation avec des tensions moyennes instantanées et des courants de manière à représenter des chutes de tension observées par les autres compteurs (1) en excluant le compteur ciblé.

8. La méthode selon la revendication 5, dans laquelle la grandeur de résistance de raccordement d'un compteur ciblé parmi les compteurs (1) est estimée en fonction d'une grandeur de tension au compteur ciblé, d'une tension moyenne évaluée avec les tensions de tous les compteurs, et d'une charge au compteur ciblé selon les mesures de consommation collectées en (i).

9. La méthode selon la revendication 5, comprenant de plus l'étape de comparer les grandeurs de résistances de raccordement des compteurs (1) les unes aux autres selon des critères de comparaison prédéterminés pour détecter une non-conformité électrique d'un ou plusieurs des compteurs (1).

10. La méthode selon la revendication 5, dans laquelle les grandeurs de résistance en relation avec un compteur ciblé sont calculées à partir d'un sous-ensemble d'échantillons où le compteur ciblé présente des dérivées de courant substantiellement plus élevées par rapport à une somme quadratique de dérivées de courant des autres compteurs (1).

11. La méthode selon la revendication 4, comprenant de plus l'étape de calculer un écart-type caractérisant une dispersion en relation avec une tension instantanée sur chaque compteur à partir des échantillons de la cohorte d'échantillons retenus (107) en (iv), en regard à une tension moyenne instantanée observée sur l'ensemble des compteurs (1) à partir des mesures de tension corrigées.

12. La méthode selon la revendication 1, comprenant de plus l'étape de détecter une non-conformité électrique relative à un compteur ciblé lorsque le coefficient de correction ou un écart moyen en relation avec des grandeurs de tension du compteur ciblé excède une grandeur prédéterminée.

**13.** La méthode selon la revendication 1, dans laquelle la gamme de charge est déterminée par rapport à des sommes de grandeurs électriques ou des grandeurs électriques maximales comprises dans les grandeurs électriques déterminées en (iii).

**14.** La méthode selon la revendication 1, dans laquelle les grandeurs électriques comprennent des séries temporelles de dérivées discrètes sur les courants et tensions se rapportant aux compteurs.

**15.** La méthode selon la revendication 1, comprenant de plus l'étape de déterminer, par le processeur, des valeurs de tensions moyennes sans charge pour chaque compteur à partir des grandeurs électriques déterminées en (iii), les fonctions de correction étant définies par rapport aux valeurs de tensions moyennes sans charge.

**16.** La méthode selon la revendication 15, comprenant de plus l'étape de détecter une anomalie dans les mesures de consommation par rapport aux fonctions de correction définies en (v).

**17.** Un système de correction de mesures de consommation fournies par des compteurs (1) présumés être rattachés à un même réseau (2), le système comprenant une unité de traitement (302) ayant un processeur (303) et une mémoire (304) en communication avec le processeur (303), la mémoire (304) contenant des instructions qui, lorsqu'exécutées par le processeur (303), entraîne le processeur (303) à réaliser les étapes de:

(i) collecter (53, 54) les mesures de consommation et les mettre dans la mémoire (304) sous forme d'un ensemble d'échantillons classés temporellement selon les intervalles temporels de prises des mesures de consommation par les compteurs (1);
(ii) valider (55), par le processeur (303), les échantillons en mémoire selon des critères de validation préétablis;
(iii) déterminer (56), par le processeur (303), des grandeurs électriques en relation avec des courants et des tensions se rapportant respectivement aux compteurs (1) pour chaque intervalle temporel à partir des échantillons considérés valides;
(iv) sélectionner (60), par le processeur (303), une cohorte d'échantillons retenus (107) parmi les échantillons considérés valides, qui correspondent à une gamme de charge ou une gamme de ratio de variation de charge transitée par le réseau (2) basée sur les grandeurs électriques déterminées en (iii);
(v) définir (62), par le processeur (303), des fonctions de correction des mesures de consommation en déterminant, pour chaque compteur,_à partir de la cohorte d'échantillons retenus sélectionnée en (iv), un coefficient de correction de tension applicable à une tension mesurée par le compteur d'après les mesures de consommation du compteur, le coefficient de correction de tension correspondant à une somme de différences de tension entre une tension moyenne sur l'ensemble des compteurs et la tension du compteur, ladite somme étant divisée par la somme desdites tensions du compteur; et
(vi) adapter le processeur (303), les mesures de consommation selon les coefficients de correction définis en (v).

**18.** Le système selon la revendication 17, comprenant de plus:

un réseau de communication (300) pour transmettre les mesures de consommation prises par les compteurs; et
une unité de base de données (301) connectée au réseau de communication, pour stocker les mesures de consommation et des données indicatives d'une topologie du réseau auquel les compteurs sont présumés être rattachés;

et dans lequel:

l'unité de traitement (302) est connectée au réseau de communication (300) et à l'unité de base de données; les mesures de consommation sont obtenues via le réseau de communication depuis les compteurs ou l'unité de base de données; et
les instructions entraînent de plus le processeur (303) à réaliser une étape de mettre à jour les mesures de consommation des compteurs selon les mesures de consommation adaptées en (vi).

**19.** Le système selon la revendication 18, comprenant de plus un terminal pour configurer l'unité de traitement, et dans lequel l'unité de traitement comprend de plus une interface d'entrée/sortie et une unité d'anonymisation de données pour échanger des données avec des applications dans un nuage.

**Patentansprüche**

1. Verfahren zur Korrektur, durch einen Prozessor (303) mit einem Speicher (304), von Verbrauchsmessungen, die von einer Einheit von Zählern (1) vorgenommen werden, von denen angenommen wird, dass sie an ein gleiches Netz (2) angeschlossen sind, wobei das Verfahren die Schritte enthält:

   (i) Sammeln (53, 54) der Verbrauchsmessungen und ihr Speichern im Speicher (304) in Form einer Einheit von Tastproben, die gemäß den Zeitintervallen von Verbrauchsmessung durch die Zähler zeitlich eingeordnet werden;

   (ii) Validieren (55), durch den Prozessor (303), der gespeicherten Tastproben gemäß vorgegebenen Validierungskriterien;

   (iii) Bestimmen (56), durch den Prozessor, elektrischer Größen in Verbindung mit Strömen und Spannungen, die sich je auf die Zähler beziehen, für jedes Zeitintervall ausgehend von den als gültig angesehenen Tastproben;

   (iv) Auswählen (60), durch den Prozessor, einer Kohorte von berücksichtigten Tastproben (107) unter den als gültig angesehenen Tastproben, die einem Lastbereich oder einem über das Netz gegangenen Lastvariationsverhältnisbereich basierend auf den in (iii) bestimmten elektrischen Größen entsprechen;

   (v) Definieren (62), durch den Prozessor, von Korrekturfunktionen der Verbrauchsmessungen, indem für jeden Zähler ausgehend von der in (iv) ausgewählten Kohorte von berücksichtigten Tastproben (107) ein Spannungskorrekturkoeffizient bestimmt wird, der auf eine vom Zähler gemessene Spannung gemäß den Verbrauchsmessungen des Zählers anwendbar ist, wobei der Spannungskorrekturkoeffizient einer Summe von Spannungsdifferenzen zwischen einer mittleren Spannung in der Einheit der Zähler (1) und der Spannung des Zählers entspricht, wobei die Summe durch die Summe der Spannungen des Zählers dividiert wird; und

   (vi) Anpassen, durch den Prozessor, der Verbrauchsmessungen gemäß den in (v) definierten Korrekturkoeffizienten.

2. Verfahren nach Anspruch 1, wobei der Lastbereich im Verhältnis zu einem Prozentsatz oder einer Anzahl von Tastproben bestimmt wird, die erforderlich sind, um die Kohorte von berücksichtigten Tastproben (107) zu formen.

3. Verfahren nach Anspruch 2, das außerdem die Schritte des Zählens einer Einheit von als gültig angesehenen Tastproben enthält, von denen eine Gesamtlast niedriger als eine oder gleich einer vorgegebenen Schwelle ist, und der iterativen Erhöhung der Schwelle enthält, bis der Prozentsatz oder die Anzahl von Tastproben erreicht oder überschritten ist.

4. Verfahren nach Anspruch 1, wobei die Korrekturfunktionen Korrekturen von Spannungsabfällen enthalten, die von Lastströmen erzeugt werden, die durch die Zähler (1) gegangen sind.

5. Verfahren nach Anspruch 4, wobei die Korrekturen von Spannungsabfällen Berechnungen von Netzwiderstandsgrößen aus Sicht jedes Zählers oder des Widerstands von Anschlüssen jedes Zählers an das Netz oder eines Gesamtwiderstands für jeden Zähler enthalten.

6. Verfahren nach Anspruch 5, das außerdem den Schritt der Erfassung einer elektrischen Nichtübereinstimmung bezüglich eines anvisierten Zählers unter den Zählern (1) enthält, wenn eine der für den anvisierten Zähler berechneten Größen der Widerstände unterhalb einer vorbestimmten minimalen Schwelle oder oberhalb einer vorbestimmten maximalen Schwelle liegt, oder eine Streuung der Größen eines der Widerstände des anvisierten Zählers eine vorbestimmte Schwelle überschreitet.

7. Verfahren nach Anspruch 5, wobei die Netzwiderstandsgröße aus Sicht eines anvisierten Zählers unter den Zählern (1) abhängig von Größen in Verbindung mit augenblicklichen mittleren Spannungen und Strömen geschätzt wird, um Spannungsabfälle darzustellen, die von den anderen Zählern (1) ausschließlich des anvisierten Zählers beobachtet werden.

8. Verfahren nach Anspruch 5, wobei die Anschlusswiderstandsgröße eines anvisierten Zählers unter den Zählern (1) abhängig von einer Spannungsgröße am anvisierten Zähler, einer mit den Spannungen aller Zähler ermittelten mittleren Spannung, und einer Last am anvisierten Zähler gemäß den in (i) gesammelten Verbrauchsmessungen geschätzt wird.

9. Verfahren nach Anspruch 5, das außerdem den Schritt des Vergleichs der Größen von Anschlusswiderständen der Zähler (1) miteinander gemäß vorbestimmten Vergleichskriterien enthält, um eine elektrische Nichtübereinstimmung eines oder mehrerer der Zähler (1) zu erfassen.

10. Verfahren nach Anspruch 5, wobei die Widerstandsgrößen in Verbindung mit einem anvisierten Zähler ausgehend von einer Teileinheit von Tastproben berechnet werden, wobei der anvisierte Zähler deutlich höhere Stromableitungen im Verhältnis zu einer quadratischen Summe von Stromableitungen der anderen Zähler (1) aufweist.

11. Verfahren nach Anspruch 4, das außerdem den Schritt der Berechnung einer Standardabweichung enthält, die eine Streuung in Verbindung mit einer augenblicklichen Spannung an jedem Zähler ausgehend von den Tastproben der Kohorte von in (iv) berücksichtigten Tastproben (107) im Hinblick auf eine in der Einheit der Zähler (1) beobachtete augenblickliche mittlere Spannung ausgehend von den korrigierten Spannungsmessungen kennzeichnet.

12. Verfahren nach Anspruch 1, das außerdem den Schritt der Erfassung einer elektrischen Nichtübereinstimmung bezüglich eines anvisierten Zählers enthält, wenn der Korrekturkoeffizient oder eine mittlere Abweichung in Verbindung mit Spannungsgrößen des anvisierten Zählers eine vorbestimmte Größe überschreitet.

13. Verfahren nach Anspruch 1, wobei der Lastbereich im Verhältnis zu Summen elektrischer Größen oder maximalen elektrischen Größen bestimmt wird, die in den in (iii) bestimmten elektrischen Größen enthalten sind.

14. Verfahren nach Anspruch 1, wobei die elektrischen Größen Zeitreihen von diskreten Ableitungen bei den sich auf die Zähler beziehenden Ströme und Spannungen enthalten.

15. Verfahren nach Anspruch 1, das außerdem den Schritt enthält, durch den Prozessor mittlere Spannungswerte ohne Last für jeden Zähler ausgehend von den in (iii) bestimmten elektrischen Größen zu bestimmen, wobei die Korrekturfunktionen im Verhältnis zu den mittleren Spannungswerten ohne Last definiert werden.

16. Verfahren nach Anspruch 15, das außerdem den Schritt der Erfassung einer Anomalie in den Verbrauchsmessungen im Verhältnis zu den in (v) definierten Korrekturfunktionen enthält.

17. System zur Korrektur von Verbrauchsmessungen, die von Zählern (1) geliefert werden, von denen angenommen wird, dass sie an ein gleiches Netz (2) angeschlossen sind, wobei das System eine Verarbeitungseinheit (302) enthält, die einen Prozessor (303) und einen Speicher (304) in Verbindung mit dem Prozessor (303) hat, wobei der Speicher (304) Anweisungen enthält, die, wenn sie vom Prozessor (303) ausgeführt werden, den Prozessor (303) veranlassen, die Schritte durchzuführen:

   (i) Sammeln (53, 54) der Verbrauchsmessungen und ihr Speichern im Speicher (304) in Form einer Einheit von Tastproben, die gemäß den Zeitintervallen von Verbrauchsmessungen durch die Zähler (1) zeitlich eingeordnet werden;
   (ii) Validieren (55), durch den Prozessor (303), der gespeicherten Tastproben gemäß vorgegebenen Validierungskriterien;
   (iii) Bestimmen (56), durch den Prozessor (303), von elektrischen Größen in Verbindung mit Strömen und Spannungen, die sich je auf die Zähler (1) beziehen, für jedes Zeitintervall ausgehend von den als gültig angesehenen Tastproben;
   (iv) Auswählen (60), durch den Prozessor (303), einer Kohorte von berücksichtigten Tastproben (107) unter den als gültig angesehenen Tastproben, die einem Lastbereich oder einem über das Netz gegangenen Lastvariationsverhältnisbereich basierend auf den in (iii) bestimmten elektrischen Größen entsprechen;
   (v) Definieren (62), durch den Prozessor (303), von Korrekturfunktionen der Verbrauchsmessungen, indem für jeden Zähler ausgehend von der in (iv) ausgewählten Kohorte von berücksichtigten Tastproben (107) ein Spannungskorrekturkoeffizient bestimmt wird, der auf eine vom Zähler gemessene Spannung gemäß den Verbrauchsmessungen des Zählers anwendbar ist, wobei der Spannungskorrekturkoeffizient einer Summe von Spannungsdifferenzen zwischen einer mittleren Spannung in der Einheit der Zähler und der Spannung des Zählers entspricht, wobei die Summe durch die Summe der Spannungen des Zählers dividiert wird; und
   (vi) Anpassen, durch den Prozessor (303), der Verbrauchsmessungen gemäß den in (v) definierten Korrekturkoeffizienten.

18. System nach Anspruch 17, das außerdem enthält:

   ein Kommunikationsnetz (300), um die von den Zählern durchgeführten Verbrauchsmessungen zu übertragen; und

eine mit dem Kommunikationsnetz verbundene Datenbankeinheit (301), um die Verbrauchsmessungen und Daten zu speichern, die eine Topologie des Netzes anzeigen, von dem angenommen wird, dass die Zähler an es angeschlossen sind; und wobei:

die Verarbeitungseinheit (302) mit dem Kommunikationsnetz (300) und mit der Datenbankeinheit verbunden ist;

die Verbrauchsmessungen über das Kommunikationsnetz von den Zählern oder der Datenbankeinheit erhalten werden; und

die Anweisungen außerdem den Prozessor (303) veranlassen, einen Schritt der Aktualisierung der Verbrauchsmessungen der Zähler gemäß den in (vi) angepassten Verbrauchsmessungen durchzuführen.

19. System nach Anspruch 18, das außerdem ein Endgerät enthält, um die Verarbeitungseinheit zu konfigurieren, und wobei die Verarbeitungseinheit außerdem eine Eingangs-/Ausgangsschnittstelle und eine Datenanonymisierungseinheit enthält, um Daten mit Anwendungen in einer Cloud auszutauschen.

**Claims**

1. A method for correcting, by a processor (303) with a memory (304), consumption measurements taken at time intervals by a set of meters (1) presumed to be connected to a same network (2), the method comprising the steps of:

(i) collecting (53, 54) the consumption measurements and storing them in the memory (304) in a form of a set of samples time-classified according to the time intervals of taking the consumption measurements by the meters;
(ii) validating (55), by the processor (303), the samples in memory according to predetermined validation criteria;
(iii) determining (56), by the processor, electrical quantities in relation with currents and voltages respectively relating to the meters for each time interval from the samples considered to be valid;
(iv) selecting (60), by the processor, a group of retained samples (107) among the samples considered to be valid, that correspond to a load range or a range of load variation ratio carried by the network based on the electrical quantities determined in (iii);
(v) defining (62), by the processor, correction functions of the consumption measurements by determining, for each meter, from the group of retained samples (107) selected in (iv), a voltage correction coefficient applicable to a voltage measured by the meter from the consumption measurements of the meter, the voltage correction coefficient corresponding to a sum of voltage differences between an average voltage over the set of meters (1) and the voltage of the meter, said sum being divided by the sum of said voltages of the meter; and
(vi) adapting, by the processor, the consumption measurements according to the correction coefficients defined in (v).

2. The method according to claim 1, wherein the load range is determined with respect to a percentage or a number of samples required for forming the group of retained samples (107).

3. The method according to claim 2, further comprising the steps of counting a set of samples considered to be valid whose total load is below or equal to a predefined threshold, and iteratively increasing the threshold until the percentage or the number of samples is reached or exceeded.

4. The method according to claim 1, wherein the correction functions comprise corrections of voltage drops generated by load currents carried by the meters (1).

5. The method according to claim 4, wherein the corrections of voltage drops comprise calculations of quantities of network resistance seen by each meter or of connection resistance of each meter to the network, or of total resistance for each meter.

6. The method according to claim 5, further comprising the step of detecting an electrical non-compliance related to a targeted meter among the meters (1) when one of the quantities calculated for the targeted meter is below a predetermined minimum threshold or above a predetermined maximum threshold, or a dispersion of the quantities of one of the resistances of the targeted meter exceeds a predetermined threshold.

7. The method according to claim 5, wherein the quantity of network resistance seen by a targeted meter among the meters (1) is estimated as a function of quantities in relation with instantaneous average voltages and currents in order to represent voltage drops observed by the other meters (1) by excluding the targeted meter.

8. The method according to claim 5, wherein the quantity of connection resistance of a targeted meter among the meters (1) is estimated as a function of a quantity of voltage at the targeted meter, of an average voltage estimated with the voltages of all the meters, and of a load at the targeted meter according to the consumption measurements collected in (i).

9. The method according to claim 5, further comprising the step of comparing the quantities of connection resistances of the meters (1) to one another according to predetermined comparison criteria for detecting an electrical non-compliance of one or several of the meters (1).

10. The method according to claim 5, wherein the quantities of resistance in relation with a targeted meter are calculated from a subset of samples where the targeted meter exhibits derivatives of current substantially higher with respect to a quadratic sum of derivatives of current of the other meters (1).

11. The method according to claim 4, further comprising the step of calculating a standard deviation characterizing a dispersion in relation with an instantaneous voltage on each meter from the samples of the group of retained samples (107) in (iv), with regard to an instantaneous average voltage observed on all the meters (1) from the corrected voltage measurements.

12. The method according to claim 1, further comprising the step of detecting an electrical non-compliance related to a targeted meter when the correction coefficient or an average deviation in relation with voltage quantities of the targeted meter exceeds a predetermined quantity.

13. The method according to claim 1, wherein the load range is determined with respect to sums of electrical quantities or maximum electrical quantities comprised in the electrical quantities determined in (iii).

14. The method according to claim 1, wherein the electrical quantities comprise time-series of discrete derivatives on the currents and voltages relating to the meters.

15. The method according to claim 1, further comprising the step of determining, by the processor, no-load average voltage values for each meter from the electrical quantities determined in (iii), the correction functions being defined with respect to the no-load average voltage values.

16. The method according to claim 15, further comprising the step of detecting an outlier in the consumption measurements with respect to the correction functions defined in (v).

17. A system for correcting consumption measurements provided by meters (1) presumed to be connected to a same network (2), the system comprising a processing unit (302) having a processor (303) and a memory (304) in communication with the processor (303), the memory (304) containing instructions that, when executed by the processor (303), cause the processor (303) to perform the steps of:

   (i) collecting (53, 54) the consumption measurements and storing them in the memory (304) in a form of a set of samples time-classified according to the time intervals of taking the consumption measurements by the meters (1);
   (ii) validating (55), by the processor (303), the samples in memory according to predetermined validation criteria;
   (iii) determining (56), by the processor (303), electrical quantities in relation with currents and voltages respectively relating to the meters (1) for each time interval from the samples considered to be valid;
   (iv) selecting (60), by the processor (303), a group of retained samples (107) among the samples considered to be valid, that correspond to a load range or a range of load variation ratio carried by the network (2) based on the electrical quantities determined in (iii);
   (v) defining (62), by the processor (303), correction functions of the consumption measurements by determining, for each meter, from the group of retained samples selected in (iv), a voltage correction coefficient applicable to a voltage measured by the meter from the consumption measurements of the meter, the voltage correction coefficient corresponding to a sum of voltage differences between an average voltage over the set of meters and the voltage of the meter, said sum being divided by the sum of said voltages of the meter; and
   (vi) adapting, by the processor (303), the consumption measurements according to the correction coefficients defined in (v).

18. The system according to claim 17, further comprising:

a communication network (300) for transmitting the consumption measurements taken by the meters; and
a database unit (301) connected to the communication network, for storing the consumption measurements
and data indicative of a topology of the network to which the meters are presumed to be connected;

and wherein:

the processing unit (302) is connected to the communication network (300) and to the database unit;
the consumption measurements are obtained via the communication network from the meters or the database
unit; and
the instructions further cause the processor (303) to perform a step of updating the consumption measurements
of the meters according to the consumption measurements adapted in (vi).

19. The system according to claim 18, further comprising a terminal for configuring the processing unit, and wherein
the processing unit further comprises an input/output interface and a data anonymization unit for exchanging data
with cloud applications.

Réseau
basse-tension

FIG. 1

FIG. 2

FIG. 3

Échantillons validées —100

Déterminer $C_{min}$, $C_{max}$ initial et $C_{step}$ —101

Calcul du seuil $N_{LowC}$ —102

Calcul la somme des courants $\Sigma C$ pour chaque échantillon —103

Sélectionner les échantillons à retenir parmi les $M$ échantillons

$m = 0$, $N = 0$

Si $\Sigma C(m) \geq C_{min}$ et $\Sigma C < C_{max}$
alors $N = N+1$, $etat(m) = 1$
Vrai    sinon $etat(m) = 0$
$m = m+1$
$m < M$

Faux : terminé

—104

106

$C_{max} = C_{max} + C_{step}$  ◄— Vrai —  $N < N_{LowC}$  — Faux —

105

107

Cohorte sélectionnée

## FIG. 4

## Tension moyenne - faible courant

## FIG. 5

Dispersion de la tension - faible courant

FIG. 6

Dispersion sur la dérivé de tension - faible courant

FIG. 7

FIG. 8

FIG. 9

FIG. 10

FIG. 11

FIG. 12

FIG. 13

FIG. 14A

FIG. 14B

EP 3 446 143 B1

Résistance de réseau

FIG. 15A

Résistance de connection

FIG. 15B

Résistance totale

FIG. 15C

Sélectionner réseau basse
tension _50

Identifier compteurs du réseau _52 ← BD - Description topologique _51

Charger données compteurs _54 ← BD - Mesures compteurs _53

Valider chaque échantillon _55

Calculer grandeurs électriques _56

Sélectionner cohorte
d'échantillons retenus _60

Calculer résistances $Z_i$, $r_i$, et
dispersions _57

Compenser chutes de tension _61 ← $r_i$

Pour cohorte

Calculer coefficients de
correction _62

Anomalie tension compteur _63

Anomalies résistances _58

Anomalie dispersion de tension
compteur _64

Transmission / affichage résultats
et anomalies probables _59

FIG. 16

FIG. 17

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20150241488 A
- US 20130191051 A, Stocker
- US 20160117326 A, Steigler
- US 9013173 B, Veinette

**Littérature non-brevet citée dans la description**

- **C. L. SU ; W. H. LEE et al.** Electricity theft détection in low voltage networks with smart meters using state estimation. *2016 IEEE INTERNATIONAL CONFERENCE ON INDUSTRIAL TECHNOLOGY,* 2016, 493-498